(19) Europäisches Patentamt
European Patent Office
Office européen des brevets

(11) EP 0 654 910 B1

(12) **FASCICULE DE BREVET EUROPEEN**

(45) Date de publication et mention de la délivrance du brevet:
**19.08.1998 Bulletin 1998/34**

(51) Int Cl.[6]: **H03M 13/00**

(21) Numéro de dépôt: **94402618.6**

(22) Date de dépôt: **17.11.1994**

(54) **Procédé de décodage itératif de codes en blocs concaténés**

Iteratives Dekodierverfahren verketteter Blockkodes

Iterative decoding method for concatenated block codes

(84) Etats contractants désignés:
**DE FR GB**

(30) Priorité: **19.11.1993 FR 9313858**

(43) Date de publication de la demande:
**24.05.1995 Bulletin 1995/21**

(73) Titulaire: **FRANCE TELECOM**
**75015 Paris (FR)**

(72) Inventeurs:
- **Pyndiah, Ramesh**
  **F-29280 Plouzane (FR)**
- **Glavieux, Alain**
  **F-29280 Plouzane (FR)**
- **Berrou, Claude**
  **F-29217 Le Conquet (FR)**

(74) Mandataire: **Loisel, Bertrand et al**
**Cabinet Plasseraud,**
**84, rue d'Amsterdam**
**75440 Paris Cédex 09 (FR)**

(56) Documents cités:
**EP-A- 0 229 698** **EP-A- 0 481 752**
**GB-A- 2 180 966** **US-A- 5 181 207**

- **IEE PROCEEDINGS I. SOLID- STATE & ELECTRON DEVICES, vol.136, no.1, Février 1989, STEVENAGE GB pages 57 - 63, XP47678 BATE & HONARY & FARRELL 'Error control techniques applicable to HF channels'**
- **IEEE TRANSACTIONS ON INFORMATION THEORY, vol.36, no.3, Mai 1990, NEW YORK US pages 677 - 683, XP132587 HASSAN & STARK 'On decoding concatenated codes'**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 654 910 B1

Printed by Jouve, 75001 PARIS (FR)

## Description

La présente invention concerne les transmissions numériques, dans lesquelles on utilise un codage en blocs pour corriger des erreurs de transmission.

En matière de transmission numérique de l'information (parole, image, données...), on distingue habituellement entre le codage source et le codage canal. Le codage source forme la représentation binaire du signal à transmettre. Il est normalement conçu en fonction de la nature du signal à transmettre. Beaucoup d'efforts ont été effectués ces dernières années en matière de codage source pour réduire le débit numérique tout en conservant une bonne qualité de transmission. Mais ces nouvelles techniques de codage source nécessitent une meilleure protection des bits vis-à-vis des perturbations lors de la transmission. D'autre part, les limitations physiques et économiques des composants haute fréquence (facteur de bruit, saturation de la puissance) ainsi que la réglementation sur le niveau de puissance autorisé à l'émission limitent la portée des systèmes de transmission numérique.

C'est pourquoi beaucoup de travaux ont été effectués en matière de codage canal, en particulier en matière de codage en blocs. Ce type de codage correcteur d'erreurs consiste à ajouter, à k bits d'information issus du codage source, n-k bits de redondance, et à utiliser ces bits de redondance à la réception pour corriger certaines erreurs de transmission. On appelle rendement du code le rapport R=k/n, et on définit le gain de codage G comme le rapport, exprimé en décibels, entre les énergies par bit d'information Eb nécessaires à l'entrée du récepteur sans codage et avec codage pour atteindre un taux d'erreur binaire (TEB) donné. Un objectif typique est de réaliser des codeurs et surtout les décodeurs associés de façon que : (i) le gain de codage G soit le plus élevé ($G > 5$ dB pour TEB = $10^{-5}$), (ii) le rendement du code soit le plus élevé ($R > 0{,}6$), et (iii) la complexité de décodage soit la plus faible.

Le cas du stockage de l'information numérique peut être vu comme un cas particulier de la transmission, dans lequel le canal de propagation inclut une mémoire dans laquelle l'information reste stockée plus ou moins longtemps, l'émetteur et le récepteur pouvant être confondus ou non. On comprendra donc qu'en général, les notions de codage canal et de décodage associé sont applicables au domaine du stockage de l'information de la même manière qu'à la transmission, les erreurs à corriger étant alors celles dues à la lecture ou à l'écriture dans la mémoire, à l'altération du contenu de la mémoire ou encore aux communications (à distance ou non) avec les dispositifs de lecture et d'écriture dans la mémoire.

Il est connu d'améliorer les performances des codes correcteurs d'erreurs en utilisant des techniques de concaténation. En particulier, la technique des codes produits, qui est plus précisément concernée par la présente invention, permet d'obtenir à partir de deux codes en blocs simples (c'est-à-dire ayant une faible distance de Hamming minimale d), un code dont la distance de Hamming minimale est égale au produit des distances de Hamming des codes élémentaires utilisés.

Si on désigne par $C_1$ un code en blocs de paramètres $(n_1,k_1,d_1)$ et par $C_2$ un code en blocs de paramètres $(n_2,k_2,d_2)$, l'application du code produit de $C_1$ par $C_2$ consiste à ordonner les $k_1$ x $k_2$ bits d'information successifs dans une matrice, et à coder les $k_1$ lignes de la matrice par le code $C_2$, puis les $n_2$ colonnes de la matrice résultante par le code $C_1$. Les paramètres du code produit P sont alors donnés par ($n = n_1 \times n_2$ ; $k = k_1 \times k_2$ ; $d = d_1 \times d_2$). Le rendement R du code P est égal à $R_1 \times R_2$. Le décodage du code P suivant le maximum de vraisemblance a posteriori (MVP) permet d'atteindre les performances optimales. Le gain de codage asymptotique maximal peut alors être approché par la relation $G < 10 \log_{10} (R.d)$.

Le code produit est donc très intéressant, mais le décodage suivant le MVP est généralement trop complexe, sauf dans le cas de codes en blocs courts.

Dans l'article "On decoding iterated codes", IEEE Trans. on Information theory, Vol. IT-16, N° 5, Septembre 1970, pages 624-627, S.M. Reddy, est proposé un algorithme de décodage d'un code produit construit à partir de codes élémentaires décodables par un décodeur algébrique, qui peut se résumer en trois étapes :

- décoder les colonnes de la matrice de codage en utilisant un décodeur algébrique,
- générer, pour chaque colonne, une estimation de la fiabilité des bits décodés basée sur le nombre de bits corrigés, et
- décoder les lignes par un décodeur algébrique en exploitant la fiabilité déterminée lors du décodage des colonnes.

Cet algorithme de décodage est sous optimal par rapport au MVP, et ne permet pas d'exploiter pleinement toutes les ressources du code produit.

Dans leur article "Separable MAP filters for the decoding of product and concatenated codes", Proc. ICC'93, Genève, Pages 1740-1745, Mai 1993, J. Lodge et al. ont proposé un algorithme itératif de décodage comprenant les étapes suivantes :

- décoder les colonnes en utilisant l'algorithme de Bahl (voir L.R.Bahl et al, "Optimal decoding of linear codes for minimizing symbol error rate", IEEE Trans. on Information Theory, Vol. IT-20, pages 248-287, Mars 1974) qui estime les rapports logarithmiques de vraisemblance (LLR pour "Log-Likelihood-Ratio") des bits,

- décoder les lignes en utilisant l'algorithme de Bahl et en prenant comme données d'entrée les vraisemblances (LLR) calculées lors du décodage des colonnes, et
- recommencer le décodage des colonnes avec pour données d'entrée les vraisemblances (LLR) calculées lors du décodage des lignes.

On réitère plusieurs fois le décodage des colonnes suivi par le décodage des lignes. Cet algorithme, bien qu'il conduise à des performances supérieures à celles de l'algorithme de Reddy, n'est applicable que pour des codes de longueur faible, par exemple le code de Hamming (16,11,3). Ceci est dû au fait que l'algorithme de Bahl utilise le treillis associé aux codes en blocs, qui croît exponentiellement en fonction de n-k. Cet algorithme n'est donc pas utilisable en pratique pour des codes de rendement élevés tels que, par exemple, le code BCH (63,51,5).

Dans leur article "Error control techniques applicable to HF channels", IEE Proceedings, Vol. 136, Pt. 1, No. 1, Fevrier 1989, pages 57 à 63, S.D. Bate, Honary et Farrell, section "3.2.2 Successive erasure decoding", est proposé un algorithme de décodage d'un code produit basé sur un code en blocs tel que le code RS(15,9), dans lequel le nombre de comparaisons est réduit par rapport à l'algorithme MVP en ne testant qu'un petit sous ensemble de mots tests dont les symboles les moins vraisemblables sont considérés comme des effacements.

Un but de la présente invention est de proposer un procédé de transmission de bits d'information faisant appel à un mode de décodage des codes produits qui soit bien adapté au cas des codes de rendement élevé.

L'invention propose ainsi un procédé pour détecter des bits d'information dans un signal numérique codé, au niveau d'un récepteur, le codage dudit signal numérique ayant été effectué au niveau d'un émetteur en appliquant à des bits d'information à transmettre un code en blocs correspondant au produit d'au moins deux codes en blocs systématiques élémentaires, le procédé comprenant une phase de décodage itératif incluant un nombre m de cycles de décodage, chaque cycle de décodage comportant successivement des étapes de recherche de mots de code pour chaque code en blocs élémentaire utilisé dans le code produit. A chaque étape de recherche de mots de code, on reçoit une matrice de données à composantes à valeurs multiples et une matrice de décision à composantes binaires qui, avant la première étape de recherche de la phase de décodage itératif, sont respectivement constituées par une matrice d'entrée composée d'échantillons du signal reçu et par une matrice dont les composantes sont celles de la matrice d'entrée mises sous forme binaire, et on produit une nouvelle matrice de décision et une nouvelle matrice de données pour l'étape de recherche suivante. Les bits d'information décodés sont extraits de la matrice de décision produite lors de la dernière étape de recherche de mots de codes. Chaque étape de recherche de mots de code comporte une division de la matrice de données reçue en vecteurs de données correspondant chacun à un mot de code du code élémentaire et une division correspondante de la matrice de décision reçue en vecteurs de décision, et les sous-étapes suivantes pour traiter respectivement certains au moins des couples vecteur de données/vecteur de décision:

- détermination d'un nombre p d'indices pour lesquels les composantes du vecteur de données sont les moins fiables ;
- construction d'un nombre q de mots binaires à décoder à partir desdits p indices et du vecteur de décision;
- obtention de q' mots de code sur la base de décodages algébriques du vecteur de décision et des q mots binaires à décoder ;
- sélection, parmi les q' mots de code obtenus, de celui ayant la plus faible distance euclidienne avec le vecteur de données ;
- calcul d'un vecteur de correction, chaque composante $W_j$ du vecteur de correction étant respectivement calculée en déterminant un éventuel mot concurrent ayant sa j-ième composante différente de celle du mot de code sélectionné, et en appliquant la formule :

$$W_j = \left( \frac{|M^c - M^d|}{4} - C_j^d \cdot R'_j \right) C_j^d \qquad (1)$$

  lorsqu'un mot concurrent a été déterminé, $M^d$ et $M^c$ désignant respectivement les distances euclidiennes, par rapport au vecteur de données, du mot de code sélectionné et du mot concurrent, et $C_j^d$ et $R'_j$ désignant respectivement les j-ièmes composantes du mot de code sélectionné et du vecteur de données ;
- obtention du nouveau vecteur de décision pris égal audit mot de code sélectionné; et
- calcul du nouveau vecteur de données en ajoutant le vecteur de correction multiplié par un premier coefficient de confiance au vecteur d'entrée correspondant extrait de la matrice d'entrée.

De préférence, le calcul de chaque composante $W_j$ du vecteur de correction en l'absence de détermination d'un mot concurrent relativement à cette composante est effectué selon la formule :

$$W_j = \beta_i C_j^d$$

où $\beta_i$ désigne un second coefficient de confiance. Le fait de ne pas trouver de mot concurrent pour un bit j signifie généralement que l'estimation de ce bit par le mot de code qui vient d'être sélectionné est relativement fiable. C'est pourquoi on prévoit une correction $W_j$ proportionnelle à la composante correspondante du mot sélectionné, le facteur de proportionnalité $\beta_i$ étant de préférence croissant au fur et à mesure des étapes de recherche de mots de code.

Dans un premier mode d'exécution du procédé, procurant des performances de décodage optimales, la détermination d'un éventuel mot concurrent relativement à la j-ième composante du mot de code sélectionné comprend la détermination, parmi les q' mots de code obtenus, de ceux ayant leur j-ième composante différente de celle du mot de code sélectionné et la sélection comme mot concurrent de celui des mots de code ainsi déterminés ayant la plus petite distance euclidienne avec le vecteur de données, aucun mot concurrent n'étant déterminé lorsque les q' mots de code obtenus ont tous leur j-ième composante égale à celle du mot de code sélectionné. On souhaite en général que les composantes du vecteur de correction soient calculées en identifiant un mot concurrent et en appliquant la formule (1) dans les cas où l'estimation des bits correspondants est relativement peu fiable. Le premier mode d'exécution exposé ci-dessus, dans lequel on décode typiquement un nombre relativement élevé de mots binaires, donne lieu à une bonne probabilité de trouver à la fois le mot de code optimal et les meilleurs mots concurrents potentiels pour les composantes relativement peu fiables, de sorte que chaque itération d'une étape de recherche de mots de code permet d'améliorer sensiblement la fiabilité des décisions.

Le fait d'avoir à décoder un nombre relativement important de mots binaires à chaque itération (typiquement $q \geq 15$) nécessite une puissance de calcul non négligeable. Pour certains décodeurs, on pourra préférer réduire quelque peu les performances en termes de TEB pour faciliter notablement la mise en oeuvre du décodage. Une possibilité est d'appliquer le second mode d'exécution du procédé selon l'invention, dans lequel la détermination d'un éventuel mot concurrent relativement à la j-ième composante du mot de code sélectionné comprend une comparaison entre la j-ième composante du vecteur de décision et celle du mot de code sélectionné, le vecteur de décision étant pris comme mot concurrent lorsque sa j-ième composante est différente de celle du mot de code sélectionné, et aucun mot concurrent n'étant déterminé dans le cas contraire. On peut alors réduire sensiblement le nombre q des mots binaires à décoder (typiquement $q \leq 6$) puisqu'il suffit de trouver un mot de code optimal parmi les résultats des q + 1 décodages, sans avoir à trouver en plus des mots concurrents potentiels pour les différentes composantes peu fiables du vecteur d'entrée, le vecteur de décision obtenu à l'itération précédente étant le seul mot concurrent candidat.

Bien entendu, la simplification apportée par le second mode d'exécution par rapport au premier a pour contrepartie une certaine dégradation des performances de décodage. Cette dégradation peut être acceptable pour certaines applications, et elle peut d'ailleurs être limitée par des dispositions appropriées. Selon l'une de ces dispositions, l'obtention des q' mots de code comprend, pour chaque mot de code résultant du décodage algébrique du vecteur de décision ou d'un des q mots binaires à décoder, l'identification des composantes du vecteur d'entrée associé ayant un signe contraire de celui de la composante correspondante dudit mot de code, ledit mot de code étant retenu parmi les q' mots de code uniquement si les valeurs absolues desdites composantes de signe contraire du vecteur d'entrée sont toutes inférieures à un seuil préétabli. On évite ainsi de modifier des éléments binaires fiables, notamment lors des premières itérations. De préférence, le seuil précité est croissant au fur et à mesure des étapes de recherche de mots de code.

Un second aspect de l'invention se rapporte à un procédé pour transmettre des bits d'information, comprenant : une phase de codage dans laquelle on applique aux bits d'information à transmettre un code en blocs correspondant au produit d'au moins deux codes en blocs systématiques élémentaires ; une phase de modulation et d'émission d'un signal obtenu à partir des bits d'information codés ; une phase de réception du signal émis après propagation et de démodulation ; et une phase de décodage itératif exécutée conformément au procédé ci-dessus exposé, pour détecter les bits d'information dans le signal reçu après démodulation.

Un troisième aspect de l'invention se rapporte à un procédé pour restituer des bits d'information stockés sous forme codée dans une mémoire, le codage desdits bits ayant été effectué en appliquant un code en blocs correspondant au produit d'au moins deux codes en blocs systématiques élémentaires, ledit procédé comprenant une phase de lecture dans la mémoire et une phase de décodage itératif effectuée conformément au procédé ci-dessus exposé, pour détecter les bits d'information dans le signal fourni par la phase de lecture.

D'autres particularités et avantages de la présente invention apparaîtront dans la description ci-après d'un exemple de réalisation préféré mais non limitatif, lue conjointement aux dessins annexés, dans lesquels :

- la figure 1 est un schéma synoptique d'une chaîne de transmission numérique utilisable pour mettre en oeuvre le procédé selon l'invention ;

- la figure 2 est un organigramme illustrant l'application d'un code produit ;
- la figure 3 est un organigramme général d'une phase de décodage itératif selon l'invention ;
- la figure 4 est un organigramme détaillant une étape de décodage de ligne ou de colonne selon un premier mode d'exécution de l'invention ;
- les figures 5 à 7 sont des graphiques illustrant des performances du décodage itératif selon le premier mode d'exécution, dans trois exemples de codes produits ;
- la figure 8 illustre partiellement une variante de l'organigramme de la figure 4 selon un second mode d'exécution de l'invention ;
- la figure 9 est un organigramme montrant une façon de sélectionner les mots de code dans le second mode d'exécution ;
- la figure 10 est un graphique comparatif illustrant les performances des premier et second modes d'exécution de l'invention ; et
- la figure 11 est un schéma synoptique d'un système de stockage d'information numérique utilisable pour mettre en oeuvre l'invention.

Dans la chaîne de transmission illustrée sur la figure 1, les bits d'information à transmettre $a_j$ sont contenus dans un signal

$$X(t)=\sum_j a_j h(t-jT)$$

adressé à l'entrée du codeur canal 12 de l'émetteur 10. Ce signal X(t) est formé par le codeur source 11 à partir d'un signal analogique S(t). Le codeur source 11 est classiquement tel que les $a_j$ soient indépendants et prennent de manière équiprobable la valeur 0 ou 1. h(t) désigne une porte temporelle de durée T qui est l'intervalle de temps séparant deux bits successifs. Le codeur canal 12 applique un codage en blocs pour produire un signal

$$Y(t)=\sum_j c_j h(t-jT')$$

où les $c_j$ sont les bits codés et T' est l'intervalle de temps séparant deux bits codés (T'< T). Le modulateur 13 transforme la séquence Y(t) en séquences de signaux compatibles avec le canal de propagation. Dans le cas d'une modulation de phase à deux états associé à un canal hertzien, un exemple du signal émis est donné par:

$$E(t)=\sum_j e_j h(t-jT_s)\sin(2\pi f_0 t)$$

où $f_0$ est la fréquence de l'onde porteuse et $e_j = 2.\ c_j - 1$. Le signal reçu au niveau de l'antenne du récepteur 15 est atténué par un coefficient $\alpha$. Le démodulateur 16 élabore le rapport de vraisemblance de chaque bit qui peut s'écrire :

$$R_j = e_j + B_j$$

où les échantillons $B_j$ sont les échantillons de bruit induits par le canal de propagation, indépendants des bits $C_j$, et non-corrélés entre eux, de moyenne nulle et d'écart type $\sigma$, fonction du rapport signal à bruit. Le signal à la sortie du démodulateur 16 est alors égal à :

$$R(t) = \sum_j R_j h(t - jT')$$

Le décodeur canal 17 prend ensuite la décision concernant les bits émis en exploitant le codage canal utilisé à l'émission pour minimiser les erreurs. Son signal de sortie est donné par :

$$Z(t) = \sum_j \hat{a}_j h(t - jT)$$

où les bits $\hat{a}_j$ sont les décisions prises par le décodeur canal. Le décodeur source 18 reconstruit ensuite le signal analogique S(t) à partir des bits fournis par le décodeur canal 17.

L'invention réside principalement dans le codeur canal 12 et le décodeur canal 17. On comprendra donc qu'elle est compatible avec divers types de codage/décodage source, de modulation/démodulation et de canaux de propagation. En particulier, l'invention peut s'appliquer dans le cadre de la télévision numérique. Le codeur 11 et le décodeur 18 peuvent alors être réalisés selon une norme MPEG (moving picture expert group), par exemple, et le modulateur 13 et le démodulateur 16 sont adaptés au canal de propagation utilisé (hertzien, filaire ....). Un autre exemple d'application est la transmission de télécopies.

Le code en blocs appliqué par le codeur canal 12 est un code produit obtenu à partir de codes élémentaires systématiques. Dans le mode de réalisation décrit ci-après, c'est le produit de deux codes en blocs linéaires $C_1$, $C_2$ de paramètres respectifs $(n_1,k_1,d_1)$ et $(n_2,k_2,d_2)$.

La procédure de codage, réalisée avec des circuits de codage classiques, est illustrée sur la figure 2. Les bits $a_j$ reçus successivement du codeur source 11 sont d'abord rangés, par groupes de $k_1$ x $k_2$ bits, selon une matrice {a} à $k_1$ lignes et $k_2$ colonnes (étape 21). Le code en blocs $C_2$ est alors appliqué à chacune des $k_1$ lignes de la matrice {a}, ce qui fournit une matrice {b} à $k_1$ lignes et $n_2$ colonnes (étape 22). Comme le code $C_2$ est systématique, $k_2$ des $n_2$ colonnes de la matrice {b} sont identiques à la matrice {a}, par exemple les $k_2$ premières colonnes. Ensuite (étape 23), le code en blocs $C_1$ est appliqué à chacune des $n_2$ colonnes de la matrice {b}, ce qui fournit une matrice {c} à $n_1$ lignes et $n_2$ colonnes dont les composantes $c_j$ sont les bits transmis successivement au modulateur 13 sous la forme du signal Y(t) (étape 24). Comme le code $C_1$ est systématique, $k_1$ des $n_1$ lignes de la matrice {c} sont identiques à la matrice {b}, par exemple les $k_1$ premières lignes. Ainsi, la partie supérieure gauche, de $k_1$ lignes et $k_2$ colonnes, de la matrice {c} est identique à la matrice {a}, les autres composantes de la matrice {c} étant des bits de redondance. Toutes les colonnes de la matrice {c} sont des mots de code du code $C_1$. De même, toutes les lignes de la matrice {c} sont des mots de code du code $C_2$, étant donné que les codes élémentaires sont linéaires.

Le décodeur canal 17 applique une procédure de décodage itératif dont l'organigramme général est présenté sur la figure 3. Après réception d'un bloc de $n_1$ x $n_2$ échantillons $R_{j1,j2}$ ($1 \le j1 \le n_1$, $1 \le j2 \le n_2$) du signal R(t) reçu du démodulateur 16, qui correspond à l'émission d'un bloc codé formé par le codeur canal 12, ces échantillons sont rangés dans une matrice d'entrée {R} à $n_1$ lignes et $n_2$ colonnes (étape 30).

Le décodage de ce bloc de $n_1$ x $n_2$ échantillons est initialisé (étape 31) en initialisant à 0 la variable de comptage i, en formant une matrice de données {R'} à $n_1$ lignes et $n_2$ colonnes dont les composantes sont initialement les mêmes que celles de la matrice d'entrée {R}, et en formant une matrice de décision {D} à $n_1$ lignes et $n_2$ colonnes dont les composantes sont binaires (-1 ou +1) et, initialement, représentent chacune le signe de la composante correspondante de la matrice d'entrée {R} : $D_{j1,j2} = \mathrm{sgn}(R_{j1,j2}) = \pm 1$.

Après cette initialisation, le décodage itératif comporte un nombre m de cycles de décodage. Chaque cycle de décodage comporte successivement une étape 32 de recherche de mots du code $C_1$ dans les colonnes de la matrice de données, et une étape 33 de recherche de mots du code $C_2$ dans les lignes de la matrice de données.

A chaque étape de recherche 32 ou 33, on calcule de nouvelles valeurs des composantes de la matrice de décision {D} et de la matrice de données {R'} qui sont utilisées pour l'étape de recherche suivante. Chaque étape de recherche 32 ou 33 peut être vue comme un filtrage appliqué à la matrice de données {R'} pour réduire l'incidence des échantillons de bruit $B_{j1,j2}$ sur les composantes $R'_{j1,j2}$ de cette matrice.

Les étapes 32 et 33 sont essentiellement identiques si on permute le rôle de lignes et des colonnes des matrices. A l'initialisation 36 de l'étape de recherche 32, la variable de comptage i est incrémentée d'une unité, et l'indice de colonne j2 est initialisé à 1. On effectue un décodage, selon le code $C_1$, du mot de données correspondant à la j2-ième colonne de la matrice {R'} (étape 37), ce qui fournit de nouvelles valeurs des composantes $D_{j,j2}$ et $R'_{j,j2}$ des matrices {D} et {R'} ($1 \le j \le n_1$). L'étape de décodage 37 est suivie par une comparaison 38 entre l'indice de colonne j2 et le nombre de colonnes $n_2$. Lorsque j2 reste inférieur à $n_2$, l'indice j2 est incrémenté d'une unité (étape 39), puis l'étape de décodage 37 est répétée. Lorsque j2 devient égal à $n_2$, toutes les colonnes ayant été traitées, on commence l'autre étape 33 de recherche de mots de code du cycle de décodage en cours. A l'initialisation 41 de l'étape de recherche 33, la variable de comptage i est incrémentée d'une unité, et l'indice de ligne j1 est initialisé à 1. On effectue un décodage, selon le code $C_2$, du mot de données correspondant à la j1-ième ligne de la matrice {R'} (étape 42), ce qui fournit de nouvelles valeurs des composantes $D_{j1,j}$ et $R'_{j1,j}$ des matrices {D} et (R'). L'étape de décodage 42 est suivie par une comparaison 43 entre l'indice de ligne j1 et le paramètre $n_1$ du code $C_1$. Lorsque j1 reste inférieur à $n_1$, l'indice j1 est incrémenté d'une unité (étape 44), puis l'étape de décodage 42 est répétée. Lorsque j1 devient égal à $n_1$, l'étape 33 de recherche de mots de code est terminée, et la variable de comptage i est comparée à 2m (test 45). Lorsque i reste inférieur à 2m, on revient à l'étape de recherche 32 pour commencer le cycle de décodage suivant. Lorsque i devient égal à 2m, les m cycles de décodage ayant été accomplis, on extrait (étape 46) les $k_1$ x $k_2$ bits d'information décodés $\hat{a}_{j1,j2}$ de la matrice de décision {D} produite lors de la dernière étape 33 de recherche de mots de code. Avec les codes systématiques $C_1$, $C_2$ appliqués de la façon décrite plus haut en référence à la figure 2, les $\hat{a}_{j1,j2}$ peuvent être simplement récupérés dans les $k_1$ premières lignes et les $k_2$ premières colonnes de la matrice {D} : $\hat{a}_{j1,j2} = D_{j1,j2}$ ($1 \le j1 \le k_1$, $1 \le j2 \le k_2$). Ces $\hat{a}_{j1,j2}$ sont à valeurs -1 ou +1 ; ils peuvent aisément être convertis pour prendre les valeurs 0 ou 1.

L'étape 37 de décodage d'un mot de données correspondant à une colonne de la matrice de données, dans un premier mode d'exécution de l'invention, est détaillée sur l'organigramme de la figure 4. Lors de cette étape 37, on traite un vecteur de données [R'] et un vecteur de décision [D], de longueur $n_1$, constituant respectivement des subdivisions de la matrice de données {R'} et de la matrice de décision {D} : $R'_j = R'_{j,j2}$ et $D_j = D_{j,j2}$ ($1 \le j \le n_1$). On repère d'abord (étape 51) les p composantes les moins fiables du vecteur [R'], c'est-à-dire les composantes de [R'] qui sont les plus proches du seuil de décision binaire (zéro). Les indices correspondant à ces p composantes les moins fiables sont notés r1, r2, ..., rp, avec

$$|R'_{r1}| < |R'_j| \qquad \forall j \neq r1$$

$$|R'_{r2}| < |R'_j| \qquad \forall j \neq r1,r2 \qquad \text{etc...}$$

Ayant identifié ces p indices, on construit q séquences binaires de test $[T^1]$,...,$[T^q]$ de longueur $n_1$, puis q mots binaires à décoder $[U^1]$,..., $[U^q]$ de longueur $n_1$ en combinant chacune des q séquences de test avec le vecteur de décision [D] (étape 52). On construit chaque mot $[U^s]$ de façon que toutes ses composantes autres que celles correspondant aux p indices r1,...,rp soient égales aux composantes correspondantes du vecteur de décision [D] : $U_j^s = D_j$ pour j ≠ r1,...,rp. Il suffit généralement de prendre en compte des mots $[U^s]$ qui n'ont qu'une ou deux composantes différentes des composantes correspondantes du vecteur [D]. Tous ces mots sont pris en compte lorsque q = p(p+1)/2. A titre d'exemple, lorsque p = 6 et q = 21, on peut construire les séquences $[T^s]$ et $[U^S]$ ($1 \le s \le q$) de la façon suivante :

* les p = 6 premières séquences de test $[T^s]$ ont un bit égal à +1 en position rs et des bits égaux à -1 aux autres positions : $T_{rs}^s = +1$ et $T_j^s = -1$ pour $1 \le s \le 6$ et j ≠ rs ;
*

| | |
|---|---|
| $[T^7] = [T^1] \oplus [T^2]$ | $[T^{15}] = [T^2] \oplus [T^6]$ |
| $[T^8] = [T^1] \oplus [T^3]$ | $[T^{16}] = [T^3] \oplus [T^4]$ |
| $[T^9] = [T^1] \oplus [T^4]$ | $[T^{17}] = [T^3] \oplus [T^5]$ |
| $[T^{10}] = [T^1] \oplus [T^5]$ | $[T^{18}] = [T^3] \oplus [T^6]$ |
| $[T^{11}] = [T^1] \oplus [T^6]$ | $[T^{19}] = [T^4] \oplus [T^5]$ |
| $[T^{12}] = [T^2] \oplus [T^3]$ | $[T^{20}] = [T^4] \oplus [T^6]$ |
| $[T^{13}] = [T^2] \oplus [T^4]$ | $[T^{21}] = [T^5] \oplus [T^6]$ |
| $[T^{14}] = [T^2] \oplus [T^5]$ | |

où ⊕ désigne l'opération OU exclusif, composante par composante, entre deux vecteurs ;

* $[U^s] = [T^s] \oplus [D]$ pour $1 \le s \le q$

A l'étape suivante 53, on effectue un décodage algébrique du vecteur de décision [D] et des q mots $[U^s]$. Pour ce décodage algébrique, on utilise par exemple, dans le cas de codes BCH, un décodeur de Berlekamp, qui est bien connu dans le domaine du codage par blocs (voir E.R. Berlekamp, "Algebric Coding Theory", M$^c$ Graw-Hill, New-York, 1968). Les q + 1 décodages élémentaires fournissent q' mots de codes $[C^1]$,..., $[C^{q'}]$ du code $C_1$. Dans le cas général, $q' \leq q + 1$, car d'une part certains mots de code peuvent apparaître plusieurs fois dans les résultats des décodages, et d'autre part le décodeur algébrique peut ne pas trouver certains mots de code si le signal est très perturbé. Les mots four-nis comme résultats du décodage algébrique doivent donc être vérifiés pour déterminer s'ils constituent ou non des mots du code $C_1$. Cette vérification peut s'effectuer simplement en multipliant chaque mot obtenu par la matrice de vérification de parité relative au code $C_1$ et en éliminant le mot si le résultat de la multiplication n'est pas nul. Toutefois, dans le cas où le code $C_1$ est parfait (c'est-à-dire tel qu'aucun mot de $n_1$ bits n'est éloigné de tous les mots de codes possibles de plus de $(d_1-1)/2$, ce qui est le cas notamment pour les codes de Hamming), l'étape de vérification des résultats du décodeur algébrique est inutile.

Parmi les q' mots de codes trouvés, on sélectionne (étape 54) celui $[C^d]$ qui présente la plus faible distance euclidienne $M^d = \|[C^d] - [R']\|^2$ avec le vecteur de données [R'].

On effectue ensuite une boucle de calcul des composantes $W_j$ d'un vecteur de correction [W] ($1 \leq j \leq n_1$). Au début de cette boucle (étape 55), l'indice de composante j est initialisé à 1. A chaque itération dans cette boucle, on effectue une étape de test 56 pour déterminer si, parmi les q' mots de code trouvés à l'étape 53, il en existe au moins un $[C^s]$ ayant sa j-ième composante différente de celle du mot de code sélectionné $[C^d]$ ($C_j^s \neq C_j^d$). S'il existe un ou plusieurs mots de code $[C^s]$ vérifiant cette condition, on détermine (étape 57) la plus petite distance euclidienne $M^c$ entre le vecteur de données [R'] et l'un quelconque de ces mots de code :

$$M^c = \min_{C_j^s \neq C_j^d} (\| [C^s] - [R'] \|^2)$$

Le mot de code $[C^c]$ qui présente cette distance $M^c$ par rapport au vecteur de données [R'] est appelé mot concurrent relativement à la j-ième composante. La composante $W_j$ est alors calculée à l'étape 58 selon la formule :

$$W_j = \left( \frac{M^c - M^d}{4} - C_j^d . R'_j \right) . C_j^d$$

On observera que la quantité $M^c$-$M^d$ intervenant dans cette formule est toujours positive de sorte que $|M^c-M^d| = M^c-M^d$. Si l'étape de test 56 ne révèle aucun mot de code $[C^s]$ tel que $C_j^s \neq C_j^d$, c'est-à-dire si aucun mot concurrent ne peut être déterminé, la composante $W_j$ est calculée à l'étape 59 selon la formule :

$$W_j = (\beta_i - C_j^d . R'_j) . C_j^d \qquad (2)$$

où $\beta_i$ désigne un coefficient de confiance positif. Après calcul de la composante de correction $W_j$, l'indice de composante j est comparé à la longueur $n_1$ du vecteur [R'] (étape 60). Lorsque j reste inférieur à $n_1$, l'indice j est incrémenté d'une unité (étape 61), et l'itération suivante est effectuée en commençant par le test 56.

Lorsque j devient égal à $n_1$, la boucle est terminée, et l'étape de décodage 37 se termine par la mise à jour 62 du vecteur de données [R'] et du vecteur de décision [D]. Le nouveau vecteur [R'] est pris égal à la somme du vecteur d'entrée [R] (dont chaque composante $R_j$ est extraite de la matrice d'entrée (R) : $R_j = R_{j,j2}$), et du vecteur de correction [W] multiplié par un autre coefficient de confiance positif $\alpha_i$ : $[R'] = [R] + \alpha_i[W]$. Le nouveau vecteur de décision [D] est pris égal au mot de code $[C^d]$ sélectionné à l'étape 54.

Dans une variante avantageuse du premier mode d'exécution de l'invention, la formule (2) appliquée le cas échéant à l'étape 59 est remplacée par :

$$W_j = \beta_i C_j^d \qquad (2')$$

qui procure une correction $W_j$ directement proportionnelle au signe de la nouvelle décision $C_j^d$. D'autres formules faisant intervenir un coefficient de confiance pourraient encore être utilisées lorsqu'aucun mot concurrent n'est identifié.

Etant donné que, dans le premier mode d'exécution de l'invention, le vecteur de décision déterminé à l'itération précédente n'intervient pas dans la boucle de calcul du vecteur de correction [W], il est indifférent de mettre à jour le vecteur de décision [D] avant cette boucle (par exemple après l'étape de sélection 54) ou après cette boucle (par exemple en même temps que la mise à jour 62 du vecteur de données [R'] comme l'illustre la figure 4).

Les étapes 42 de décodage de mots de données correspondant à des lignes de la matrice de données sont semblables aux étapes 37 détaillées ci-dessus en référence à la figure 4, en remplaçant le code $C_1$ par le code $C_2$, et la longueur $n_1$ par la longueur $n_2$, et en divisant les matrices {R'}, {D}, {R} non pas en vecteurs colonnes [R'], [D], [R], mais en vecteurs lignes.

Les coefficients de confiance $\alpha_i$ et $\beta_i$ sont affectés d'un indice qui correspond à la variable de comptage i de l'organigramme de la figure 3. En effet, ces coefficients $\alpha_i$, $\beta_i$ peuvent varier d'une étape de recherche 32, 33 à une autre. De préférence, les $\alpha_i$ et $\beta_i$ croissent au fur et à mesure des étapes de recherche de mots de code 32, 33, pour tenir compte de la fiabilité croissante du décodage.

La demanderesse a essayé le procédé décrit ci-dessus en référence aux figures 1 à 4 pour différents codes produits dans le cadre de simulations numériques. La modulation considérée pour le signal émis était une modulation de phase à deux états (MDP2), et le canal de propagation était modélisé par un canal à bruit blanc additif gaussien. Les séquences de test [$T^s$] et les mots à décoder [$U^s$] étaient déterminés à l'étape 52 de la façon détaillée plus haut, avec p = 6 et q = 21. Des résultats sont exposés ci-après dans le cas de trois codes produits de rendements élevés, obtenus à partir de codes systématiques élémentaires de type Bose-Chaudhuri-Hocquenghem (BCH).

<u>Exemple 1</u> : $C_1 = C_2$ = BCH (63,57,3)

Le code BCH (63,57,3) est un code de Hamming et est donc parfait. Le code produit présente alors les propriétés suivantes :

- distance de Hamming minimale d = 9
- rendement de codage R = 0,82
- gain de codage G < 8,7 dB

Les coefficients de confiance $\alpha_i$, $\beta_i$ ont été choisis de la façon suivante :

| | |
|---|---|
| $\alpha_1 = 0,2$ | $\beta_1 = 0,5$ |
| $\alpha_2 = 0,3$ | $\beta_2 = 0,5$ |
| $\alpha_3 = 0,4$ | $\beta_3 = 1,0$ |
| $\alpha_4 = 0,4$ | $\beta_4 = 1,5$ |
| $\alpha_5 = 0,5$ | $\beta_5 = 1,5$ |
| $\alpha_6 = 0,5$ | $\beta_6 = 2,0$ |
| $\alpha_7 = 0,7$ | $\beta_7 = 2,0$ |
| $\alpha_8 = 0,7$ | $\beta_8 = 3,0$ |
| $\alpha_9 = 0,8$ | $\beta_9 = 3,0$ |
| $\alpha_{10} = 0,8$ | $\beta_{10} = 4,0$ |

<u>Exemple 2</u> : $C_1 = C_2$ = BCH (63,51,5)

Le code produit présente alors les propriétés suivantes :

- distance de Hamming minimale d = 25
- rendement de codage R = 0,66
- gain de codage G < 12 dB

Les coefficients de confiance $\alpha_i$, $\beta_i$ ont été choisis de la façon suivante :

| | |
|---|---|
| $\alpha_1 = 0,3$ | $\beta_1 = 0,5$ |
| $\alpha_2 = 0,3$ | $\beta_2 = 0,5$ |
| $\alpha_3 = 0,4$ | $\beta_3 = 1,0$ |
| $\alpha_4 = 0,4$ | $\beta_4 = 1,5$ |

(suite)

| | |
|---|---|
| $\alpha_5 = 0,5$ | $\beta_5 = 1,5$ |
| $\alpha_6 = 0,5$ | $\beta_6 = 2,0$ |
| $\alpha_7 = 0,5$ | $\beta_7 = 2,0$ |
| $\alpha_8 = 0,5$ | $\beta_8 = 3,0$ |
| $\alpha_9 = 0,6$ | $\beta_9 = 3,0$ |
| $\alpha_{10} = 0,6$ | $\beta_{10} = 5,0$ |

Exemple 3 : $C_1 = C_2$ = BCH (127,113,5)

Le code produit présente alors les propriétés suivantes :

- distance de Hamming minimale d = 25
- rendement de codage R = 0,79
- gain de codage G < 13 dB

Les coefficients de confiance $\alpha_i$, $\beta_i$ ont été choisis de la même façon que dans l'exemple 2.

Dans chacun des trois exemples, on a estimé la dépendance entre le taux d'erreur binaire (TEB) et le rapport Eb/N0, exprimé en décibels, entre l'énergie Eb du signal émis par bit d'information et la densité spectrale N0 de la puissance du bruit induit lors de la propagation. Les résultats pour les exemples 1, 2 et 3 sont illustrés respectivement sur les graphiques des figures 5, 6 et 7.

Dans chacun de ces graphiques, la courbe A correspond au cas où le codage par blocs n'est pas appliqué, à des fins de comparaison, la courbe B correspond au cas où on réalise m = 1 cycles de décodage (c'est-à-dire 2m = 2 étapes de recherche de mots de code 32, 33), la courbe C correspond au cas où on réalise m = 3 cycles de décodage, et la courbe D correspond au cas où on réalise m = 5 cycles de décodage. On peut ainsi apprécier l'amélioration sur le taux d'erreur binaire procurée par la procédure itérative de décodage.

Dans le second mode d'exécution de l'invention, le mot concurrent $[C^c]$ n'est pas choisi parmi les mots de codes issus des décodages algébriques. Le vecteur de décision [D] est considéré comme le seul mot concurrent possible relativement à chaque composante $W_j$, bien qu'il ne constitue pas nécessairement un mot du code $C_1$. En conséquence, on n'a pas besoin de décoder autant de mots que dans le premier mode d'exécution. Typiquement, on aura p = q = 3, chaque mot à décoder $[U^s]$ différant du vecteur de décision [D] par une seule de ses composantes. L'organigramme de la figure 3 reste valable pour le second mode d'exécution, de même que les étapes 51 à 54 illustrées sur la figure 4. La boucle de calcul des composantes $W_j$ des vecteurs de correction [W] peut être effectuée de la manière représentée sur la figure 8. A l'initialisation 550 de l'indice de composante j, on calcule en outre la distance $M^c = \| [D] - [R'] \|^2$ entre le mot concurrent candidat [D] et le vecteur de données [R']. A chaque itération dans la boucle, on compare (test 560) les j-ièmes composantes respectives du vecteur de décision [D] et du mot de code $[C^d]$ sélectionné à l'étape 54. Si $D_j = C_j^d$, aucun mot concurrent n'est retenu relativement à la j-ième composante, et on prend $W_j = \beta_i C_j^d$ à l'étape 590. Si $D_j \neq C_j^d$ le vecteur [D] est retenu comme mot concurrent et on calcule, à l'étape 580 :

$$W_j = \frac{\left| M^c - M^d \right|}{4} C_j^d - R'_j$$

Après le calcul de la composante de correction $W_j$, l'indice j est comparé à la longueur $n_1$ du vecteur [R'] (étape 600). Lorsque j reste inférieur à $n_1$, l'indice j est incrémenté d'une unité (étape 610), et l'itération suivante est effectuée en commençant par le test 560. Lorsque j devient égal à $n_1$, on passe à l'étape 62 de mise à jour des vecteurs [R'] et [D] comme dans le cas de la figure 4.

Le fait de prendre le vecteur de décision [D] comme seul mot concurrent possible constitue un traitement moins précis que celui employé dans le premier mode de réalisation. On souhaite donc que ce traitement ne soit pas appliqué de manière à modifier des composantes initialement fiables du vecteur d'entrée [R], surtout lors des premières itérations. Pour cela, on peut effectuer les étapes 53 et 54 (figure 4) de la manière illustrée sur la figure 9. A l'issue de l'étape 52, on initialise la variable de comptage t à 1 et la distance $M^d$ à un nombre arbitrairement grand (étape 524). A l'étape 525, on effectue le décodage algébrique du t-ième mot à décoder pour obtenir un mot binaire $[E^t]$ (il y a au total q + 1 mots à décoder : l'an-cien vecteur de décision [D] et les q mots $[U^s]$ construits à l'étape 52). Si le code $C_1$ n'est pas un code parfait, on vérifie en 526 si le mot binaire $[E^t]$ appartient au code $C_1$, en le multipliant par la matrice de vérification de parité du code $C_1$. Dans la négative, le mot $[E^t]$ est éliminé et on compare, en 527, la variable t au nombre q + 1. Quand t devient égal à q+1, tous les décodages ont été faits et on passe à l'étape 550 décrite précédemment en référence à la figure 8. Si la comparaison 527 montre que t reste inférieur à q+1, la variable t est incrémentée d'une unité en 528 et on revient à l'étape de décodage 525 pour le mot suivant.

Si la vérification de parité 526 montre que le mot $[E^t]$ appartient au code $C_1$, on effectue une boucle de vérification des composantes du mot $[E^t]$. A l'initialisation 529 de cette boucle, l'indice de composante j est initialisé à 1 et le nombre L à 0. A chaque itération dans cette boucle on compare, en 530, le signe de la j-ième composante $R_j$ du vecteur d'entrée [R] à la valeur binaire de la j-ième composante $E_j^t$ du mot $[E^t]$. Si $sgn(R_j) = E_j^t$, on passe à l'étape 532. La condition $sgn(R_j) \neq E_j^t$ traduit le fait que l'éventuelle sélection du mot $[E^t]$ inverserait le signe de la décision binaire par rapport à la valeur de $R_j$, ce qu'on souhaite interdire si cette valeur de $R_j$ est relativement fiable. Ainsi, si la comparaison 530 montre que $sgn\ R_j) \neq E_j^t$, on compare, en 531, la valeur absolue de $R_j$ à un seuil $\gamma_i$. Si $|R_j| > \gamma_i$, la composante $R_j$ est considérée comme fiable et on élimine donc le mot $[E^t]$ en passant directement au test 527. Si la comparaison 531 montre que $|R_j| < \gamma_i$, le mot $[E^t]$ est considéré comme acceptable en ce qui concerne sa j-ième composante, et on passe à l'étape 532. A l'étape 532, on ajoute au nombre L la quantité $(E_j^t\text{-}R_j')^2$. Ensuite, on compare l'indice de composante j à la longueur $n_1$ des vecteurs (test 533). Si $j < n_1$, le test 533 est suivi par une incrémentation 534 de l'indice j, et par la comparaison 530 relative à l'itération suivante. Si le test 533 montre que $j = n_1$, le mot $[E^t]$ a été accepté pour toutes ses composantes (en d'autres termes sup $\{ |R_j| / sgn(R_j) \neq E_j^t\} < \gamma_i$), et il fait alors partie des q' mots de code pouvant être sélectionnés pour former le prochain vecteur de décision, le nombre L étant égal à sa distance euclidienne par rapport au vecteur de données [R'].

Une fois que le mot $[E^t]$ a été retenu parmi lesdits q' mots de code, on compare les nombres L et $M^d$ (test 535). Si $L < M^d$, la nouvelle valeur de $M^d$ est prise égale à L, en 536, et le mot $[C^d]$ est pris égal à $[E^t]$, puis on passe au test 527. Si le test 535 montre que $L \geq M^d$, on passe directement au test 527. Ainsi lorsque tous les décodages ont été faits et les mots obtenus vérifiés (test 527 positif), le mot $[C^d]$ est le mot de code acceptable ayant la plus petite distance euclidienne par rapport au vecteur [R'], et cette distance minimale est égale à $M^d$. On passe alors au processus illustré sur la figure 8.

Si le code $C_1$ est parfait, l'étape 526 est supprimée, le décodage 525 étant directement suivi par l'initialisation 529 de la boucle de vérification des composantes du mot $[E^t]$.

Le seuil $\gamma_i$ est affecté d'un indice qui correspond à la variable de comptage i de l'organigramme de la figure 3. De préférence, le seuil $\gamma_i$ croît au fur et à mesure des étapes de recherche de mots de code 32, 33 pour tenir compte de la fiabilité croissante du décodage.

L'organigramme de la figure 9 montre une certaine imbrication entre les fonctions correspondant aux blocs 53 et 54 sur la figure 4. On comprendra que l'ordre d'exécution des principales fonctions de l'invention ainsi que l'imbrication éventuelle de ces fonctions peuvent varier dans une assez large mesure, ceci étant essentiellement une question de choix à opérer lors de la programmation des circuits de traitement du décodeur.

Les procédures illustrées aux figures 8 et 9 ont été décrites dans le cadre des étapes 37 de décodage de mots de données correspondant des colonnes de la matrice de données (figure 3). Elles sont bien entendu directement transposables au cas des lignes (étapes de décodage 42).

<u>Exemple 4 :</u> $C_1 = C_2 = BCH(64,57,4)$

La demanderesse a testé le second mode d'exécution du procédé, tel que décrit en référence aux figures 8 et 9 avec p = q = 3. Le type de canal considéré dans cette simulation était le même que celui des exemples 1 à 3. Le code produit présente les propriétés suivantes :

- distance de Hamming minimale d = 16
- rendement de codage R = 0,79
- gain de codage G < 11 dB

Les coefficients $\alpha_i$, $\beta_i$, $\gamma_i$ ont été choisis de la façon suivante :

| | | |
|---|---|---|
| $\alpha_1 = 0,3$ | $\beta_1 = 0,2$ | $\gamma_1 = 0,5$ |
| $\alpha_2 = 0,5$ | $\beta_2 = 0,3$ | $\gamma_2 = 0,7$ |
| $\alpha_3 = 0,7$ | $\beta_3 = 0,5$ | $\gamma_3 = 1,0$ |
| $\alpha_4 = 0,9$ | $\beta_4 = 0,7$ | $\gamma_4 = 1,5$ |
| $\alpha_5 = 1,0$ | $\beta_5 = 0,9$ | $\gamma_5 = 2,0$ |
| $\alpha_6 = 1,1$ | $\beta_6 = 1,0$ | $\gamma_6 = 2,5$ |
| $\alpha_7 = 1,2$ | $\beta_7 = 1,1$ | $\gamma_7 = 3,0$ |

(suite)

| | | |
|---|---|---|
| $\alpha_8 = 1,2$ | $\beta_8 = 1,2$ | $\gamma_8 = 4,0$ |

La figure 10 montre le TEB obtenu pour différentes valeurs du rapport Eb/N0 dans le cas de l'exemple 4. La courbe A correspond au cas où le codage par blocs n'est pas appliqué, la courbe B correspond à m = 4 cycles de décodage selon le second mode d'exécution du procédé, et la courbe C correspond à m = 4 cycles de décodage selon le premier mode d'exécution dans les mêmes conditions de simulation qu'aux exemples 1 et 3 et avec les valeurs des $\alpha_i$ et $\beta_i$ indiquées ci-dessus. Le second mode d'exécution représente un excellent compromis entre les performances de décodage et la complexité de mise en oeuvre. Le premier mode d'exécution présente les meilleures performances (amélioration de l'ordre de 0,7 dB pour un TEB de $10^{-5}$), et pourra être adopté notamment dans les applications où la simplicité de mise en oeuvre n'est pas un facteur critique.

Bien entendu, la procédure de décodage du procédé selon l'invention peut être exécutée selon un organigramme qui diffère quelque peu de ceux illustrés précédemment. Par exemple, au lieu de transmettre la matrice {R'} d'une étape de recherche de mots de code 32, 33 à la suivante, il est possible de transmettre une matrice de correction {W} dont les composantes sont calculées, pour chaque colonne ou ligne, comme indiqué aux étapes 58 et 59 sur la figure 4 ou aux étapes 580 et 590 sur la figure 8. Dans ce cas, la dernière étape 62 de l'organigramme de la figure 4 ne fait pas partie des étapes de décodage 37 ou 42. Les vecteurs de données [R'] sont formés au début de chaque étape de décodage 37 ou 42 en ajoutant à un vecteur ligne ou colonne [R] de la matrice d'entrée, le vecteur ligne ou colonne correspondant de la matrice {W}, multiplié par le coefficient $\alpha_{i-1}$ (avec $\alpha_0 = 0$). Les matrices {R'}, {R} et {W} étant liées, il est équivalent, pour transmettre la matrice de données, de mémoriser {R} et {R'} comme indiqué précédemment, ou de mémoriser {R} et {W}.

Les décodages algébriques effectués aux étapes 53 ou 525 peuvent être réalisés au moyen de circuits décodeurs classiques. Un seul circuit décodeur est d'ailleurs nécessaire lorsque les codes élémentaires sont les mêmes. Le reste de la procédure de décodage itératif peut aisément être effectué en programmant un processeur approprié, ou encore en utilisant un circuit spécifique.

On notera que le procédé selon l'invention est applicable au cas où le code produit résulte de produit de plus de deux codes élémentaires. Les matrices traitées sont alors à plus que deux dimensions, et chaque cycle de décodage comporte un nombre correspondant d'étapes de recherche de mots de code.

La figure 11 montre une variante de la chaîne de transmission de la figure 1 dans laquelle le canal de propagation comprend une mémoire 130, par exemple une mémoire à bandes magnétiques ou à disques optiques numériques. L'émetteur 110 produit un signal numérique codé Y(t) qu'un codeur canal 112 obtient de la manière décrite précédemment à partir de bits d'information X(t) fournis par un dispositif d'entrée de données 111. Le dispositif d'entrée 111 peut être un codeur source comme exposé précédemment. Il peut également être un ordinateur délivrant des données à mémoriser, cet ordinateur pouvant d'ailleurs assurer en outre les fonctions du codeur canal 112. Le signal codé Y(t) est adressé, directement ou par l'intermédiaire d'une ligne de transmission à l'interface 120 de la mémoire 130 pour l'écriture. Un récepteur 115 pour recevoir l'information ainsi stockée comprend un décodeur canal 117 raccordable directement ou indirectement à l'interface 120 pour lire un signal R(t) présentant en général une certaine distorsion par rapport au signal d'écriture Y(t). Le décodeur 117 applique l'un des procédés décrits ci-dessus pour fournir un signal d'estimation Z(t). Ce signal Z(t) est fourni à un dispositif de traitement 118. Le traitement appliqué par le dispositif 118 peut comprendre par exemple une autre mémorisation de l'information Z(t), des calculs sur la base de cette information, ou une représentation d'une entité physique que caractérise cette information (affichage d'images animées ou non, restitution de son, impression d'un document...). Le dispositif 118 comprendra souvent des circuits de traitement assurant en outre les fonctions du décodeur 117.

**Revendications**

1. Procédé pour détecter des bits d'information ($\hat{a}_j$) dans un signal numérique codé (R(t)), au niveau d'un récepteur (15), le codage dudit signal numérique ayant été effectué au niveau d'un émetteur (10) en appliquant à des bits d'information à transmettre ($a_j$) un code en blocs correspondant au produit d'au moins deux codes en blocs systématiques élémentaires ($C_1$, $C_2$), le procédé comprenant une phase de décodage itératif incluant un nombre m de cycles de décodage, chaque cycle de décodage comportant successivement des étapes (32,33) de recherche de mots de code pour chaque code en blocs élémentaire utilisé dans le code produit,

   caractérisé en ce que, à chaque étape (32,33) de recherche de mots de code, on reçoit une matrice de données ({R'}) à composantes à valeurs multiples et une matrice de décision ({D}) à composantes binaires qui, avant la première étape de recherche de la phase de décodage itératif, sont respectivement constituées par une matrice d'entrée ({R}) composée d'échantillons du signal reçu (R(t)) et par une matrice dont les composantes sont celles de la matrice d'entrée ({R}) mises sous forme binaire, et on produit une nouvelle matrice de décision ({D}) et une nouvelle matrice de données ({R'}) pour l'étape de recherche suivante, en ce que les bits d'information décodés ($\hat{a}_j$) sont extraits de la matrice de décision produite lors de la dernière étape de recherche de mots de code, et en ce que chaque étape (32,33) de recherche de mots de code comporte une division de la matrice de données reçue en vecteurs de données ([R']) correspondant chacun à un mot de code du code élémentaire et une division correspondante de la matrice de décision reçue en vecteurs de décision ([D]), et les sous-étapes suivantes pour traiter respectivement certains au moins des couples vecteur de données/vecteur de décision :

- détermination d'un nombre p d'indices (r1, ..., rp) pour lesquels les composantes du vecteur de données ([R']) sont les moins fiables ;
- construction d'un nombre q de mots binaires à décoder ([$U^s$]) à partir desdits p indices et du vecteur de décision ([D]) ;
- obtention de q' mots de code ([$C^s$]) sur la base de décodages algébriques du vecteur de décision et des q mots binaires à décoder ;
- sélection, parmi les q' mots de code obtenus de celui ([$C^d$]) ayant la plus faible distance euclidienne avec le vecteur de données ([R']);
- calcul d'un vecteur de correction ([W]), chaque composante $W_j$ du vecteur de correction étant respectivement calculée en déterminant un éventuel mot concurrent ([$C^c$]) ayant sa j-ième composante différente de celle du mot de code sélectionné ([$C^d$]), et en appliquant la formule :

$$W_j = \left( \frac{|M^c - M^d|}{4} - C_j^d \cdot R_j' \right) C_j^d$$

  lorsqu'un mot concurrent a été déterminé, $M^d$ et $M^c$ désignant respectivement les distances euclidiennes, par rapport au vecteur de données ([R']), du mot de code sélectionné ([$C^d$]) et du mot concurrent ([$C^c$]), et $C_j^d$ et $R'_j$ désignant respectivement les j-ièmes composantes du mot de code sélectionné et du vecteur de données ;
- obtention du nouveau vecteur de décision ([D]) pris égal audit mot de code sélectionné ([$C^d$]); et
- calcul du nouveau vecteur de données ([R']) en ajoutant le vecteur de correction ([W]) multiplié par un premier coefficient de confiance ($\alpha_i$) au vecteur d'entrée correspondant ([R]) extrait de la matrice d'entrée ({R}).

**2.** Procédé selon la revendication 1, caractérisé en ce que, dans la sous-étape de calcul d'un vecteur de correction ([W]), la détermination d'un éventuel mot concurrent ([$C^c$]) relativement à la j-ième composante du mot de code sélectionné ([$C^d$]) comprend la détermination, parmi les q' mots de code obtenus, de ceux ayant leur j-ième composante différente de celle du mot de code sélectionné et la sélection comme mot concurrent de celui des mots de code ainsi déterminés ayant la plus petite distance euclidienne ($M^c$) avec le vecteur de données ([R']), aucun mot concurrent n'étant déterminé lorsque les q' mots de code obtenus ont tous leur j-ième composante égale à celle du mot de code sélectionné.

**3.** Procédé selon la revendication 1, caractérisé en ce que, dans la sous-étape de calcul d'un vecteur de correction ([W]), la détermination d'un éventuel mot concurrent ([$C^c$]) relativement à la j-ième composante du mot de code sélectionné ([$C^d$]) comprend une comparaison entre la j-ième composante du vecteur de décision ([D]) et celle du mot de code sélectionné ([$C^d$]), le vecteur de décision étant pris comme mot concurrent lorsque sa j-ième composante est différente de celle du mot de code sélectionné, et aucun mot concurrent n'étant déterminé dans le cas contraire.

**4.** Procédé selon l'une quelconque des revendications 1 à 3, caractérisé en ce que l'obtention des q' mots de code comprend, pour chaque mot de code ([$C^s$]) résultant du décodage algébrique du vecteur de décision ou d'un des q mots binaires à décoder, l'identification des composantes du vecteur d'entrée associé ayant un signe contraire de celui de la composante correspondante dudit mot de code, ledit mot de code étant retenu parmi les q' mots de code uniquement si les valeurs absolues desdites composantes de signe contraire du vecteur d'entrée sont toutes inférieures à un seuil préétabli ($\gamma_i$).

**5.** Procédé selon la revendication 4, caractérisé en ce que le seuil ($\gamma_i$) est croissant au fur et à mesure des étapes de recherche de mots de code (32,33).

**6.** Procédé selon l'une quelconque des revendications 1 à 5, caractérisé en ce que le premier coefficient de confiance

($\alpha_i$) est croissant au fur et à mesure des étapes de recherche de mots de code (32,33).

**7.** Procédé selon l'une quelconque des revendications 1 à 6, caractérisé en ce que le calcul de chaque composante $W_j$ du vecteur de correction ([W]) en l'absence de détermination d'un mot concurrent relativement à cette composante est effectué selon la formule :

$$W_j = \beta_i C_j^d$$

où $\beta_i$ désigne un second coefficient de confiance.

**8.** Procédé selon l'une quelconque des revendications 1 à 6, caractérisé en ce que le calcul de chaque composante $W_j$ du vecteur de correction ([W]) en l'absence de détermination d'un mot concurrent relativement à cette composante est effectué selon la formule :

$$W_j = (\beta_i \text{-} C_j^d\, R'_j) C_j^d$$

où $\beta_i$ désigne un second coefficient de confiance.

**9.** Procédé selon la revendication 7 ou 8, caractérisé en ce que le second coefficient de confiance ($\beta_i$) est croissant au fur et à mesure des étapes de recherche de mots de code (32,33).

**10.** Procédé selon l'une quelconque des revendications 1 à 9, caractérisé en ce que chacun des q mots binaires à décoder ([$U^s$]) est construit de façon que toutes ses composantes autres que celles correspondant aux p indices (r1, ..., rp) pour lesquels les composantes du vecteur de données ([R']) sont les moins fiables soient respectivement égales aux composantes correspondantes du vecteur de décision ([D]).

**11.** Procédé selon la revendication 10, caractérisé en ce que chacun des q mots binaires à décoder ([$U^s$]) est construit de façon à avoir une ou deux composantes différentes des composantes correspondantes du vecteur de décision ([D]).

**12.** Procédé selon la revendication 11, caractérisé en ce que q = p(p+1)/2.

**13.** Procédé selon l'une quelconque des revendications 1 à 12, caractérisé en ce que les codes en blocs élémentaires ($C_1$, $C_2$) utilisés dans le code produit sont identiques.

**14.** Procédé pour transmettre des bits d'information ($a_j$), comprenant :

- une phase de codage dans laquelle on applique aux bits d'information à transmettre un code en blocs correspondant au produit d'au moins deux codes en blocs systématiques élémentaires ($C_1$, $C_2$) ;
- une phase de modulation et d'émission d'un signal (E(t)) obtenu à partir des bits d'information codés ($c_j$) ;
- une phase de réception du signal émis après propagation et de démodulation ; et
- une phase de décodage itératif,

caractérisé en ce que la phase de décodage itératif est exécutée conformément à un procédé selon l'une quelconque des revendications 1 à 13, pour détecter les bits d'information ($\hat{a}_j$) dans le signal reçu après démodulation (R(t)).

**15.** Procédé pour restituer des bits d'information ($a_j$) stockés sous forme codée dans une mémoire, le codage desdits bits ayant été effectué en appliquant un code en blocs correspondant au produit d'au moins deux codes en blocs systématiques élémentaires ($C_1$, $C_2$), ledit procédé comprenant une phase de lecture dans la mémoire et une phase de décodage itératif, caractérisé en ce que la phase de décodage itératif est effectuée conformément à un procédé selon l'une quelconque des revendications 1 à 13, pour détecter les bits d'information ($\hat{a}_j$) dans le signal fourni par la phase de lecture.

**Claims**

1. Method for detecting information bits ($\hat{a}_j$) in a coded digital signal (R(t)), within a receiver (15), the coding of the said digital signal having been performed within a transmitter (10) by applying, to information bits to be transmitted ($a_j$), a block code corresponding to the product of at least two elementary systematic block codes ($C_1$, $C_2$), the method comprising an iterative decoding phase including a number m of decoding cycles, each decoding cycle successively including code word search steps (32, 33) for each elementary block code used in the product code, characterized in that, at each code word search step (32, 33), a data matrix ({R'}) with multiple-valued components and a decision matrix ({D}) with binary components are received which, before the first search step of the iterative decoding phase consist respectively of an input matrix ({R}) consisting of samples of the received signal (R(t)) and of a matrix, the components of which are those of the input matrix ({R}) put into binary form, and a new decision matrix ((D)) and a new data matrix ({R'}) are produced for the following search step, in that the decoded information bits ($\hat{a}_j$) are extracted from the decision matrix produced during the last code word search step, and in that each code word search step (32, 33) includes a division of the data matrix received into data vectors ([R']) each corresponding to a code word of the elementary code and a corresponding division of the decision matrix received into decision vectors ([D]), and the following substeps for respectively processing at least some of the data vector/ decision vector pairs:

- determining a number p of indices (r1, ... ,rp) for which the components of the data vector ([R']) are the least reliable;
- constructing a number q of binary words to be decoded ([$U^s$]) from the said p indices and from the decision vector ([D]);
- obtaining q' code words ([$C^s$]) on the basis of algebraic decodings of the decision vector and of the q binary words to be decoded;
- selecting, among the q' code words obtained, the one ([$C^d$]) having the smallest euclidean distance with the data vector ([R']);
- calculating a correction vector ([W]), each component $W_j$ of the correction vector being calculated respectively by determining a possible concurrent word ([$C^c$]) having its j-th component different from that of the selected code word ([$C^d$]), and by applying the formula:

$$W_j=\left(\frac{|M^c-M^d|}{4}-C_j^d \cdot R'_j\right)C_j^d$$

  when a concurrent word has been determined, $M^d$ and $M^c$ respectively designating the euclidean distances, with respect to the data vector ([R']), of the selected code word ([$C^d$]) and of the concurrent word ([$C^c$]), and $C_j^d$ and $R'_j$ respectively designating the j-th components of the selected code word and of the data vector;
- obtaining the new decision vector ([D]) taken to be equal to the said selected code word ([$C^d$]); and
- calculating the new data vector ([R']) by adding the correction vector ([W]) multiplied by a first confidence coefficient ($\alpha_i$) to the corresponding input vector ([R]) extracted from the input matrix ({R}).

2. Method according to Claim 1, characterized in that, in the substep of calculating a correction vector ([W]), the determination of a possible concurrent word ([$C^c$]) relatively to the j-th component of the selected code word ([$C^d$]) comprises the determination, among the q' code words obtained, of those having their j-th component different from that of the selected code word and the selection as concurrent word of that one of the code words thus determined having the smallest euclidean distance ($M^c$) with the data vector ([R']), no concurrent word being determined when the q' code words obtained all have their j-th component equal to that of the selected code word.

3. Method according to Claim 1, characterized in that, in the substep of calculating a correction vector ([W]), the determination of a possible concurrent word ([$C^c$]) relatively to the j-th component of the selected code word ([$C^d$]) comprises a comparison between the j-th component of the decision vector ([D]) and that of the selected code word ([$C^d$]), the decision vector being taken as concurrent word when its j-th component is different from that of the selected code word, and no concurrent word being determined in the opposite case.

4. Method according to any one of Claims 1 to 3, characterized in that the obtaining of the q' code words comprises, for each code word ([$C^s$]) resulting from the algebraic decoding of the decision vector or of one of the q binary words to be decoded, the identification of the components of the associated input vector having a sign opposite to that of the corresponding component of the said code word, the said code word being adopted among the q' code words only if the absolute values of the said components of opposite sign of the input vector are all less than a preestablished threshold ($\gamma_i$).

**5.** Method according to Claim 4, characterized in that the threshold ($\gamma_i$) increases in step with the code word search steps (32, 33).

**6.** Method according to any one of Claims 1 to 5, characterized in that the first confidence coefficient ($\alpha_i$) increases in step with the code word search steps (32, 33).

**7.** Method according to any one of Claims 1 to 6, characterized in that the calculation of each component $W_j$ of the correction vector ([W]) in the absence of determination of a concurrent word relatively to this component is performed according to the formula:

$$W_j = \beta_i C_j^d$$

where $\beta_i$ designates a second confidence coefficient.

**8.** Method according to any one of Claims 1 to 6, characterized in that the calculation of each component $W_j$ of the correction vector ([W]) in the absence of determination of a concurrent word relatively to this component is performed according to the formula:

$$W_j = (\beta_i - C_j^d R'_j)\ C_j^d$$

where $\beta_i$ designates a second confidence coefficient.

**9.** Method according to Claim 7 or 8, characterized in that the second confidence coefficient ($\beta_i$) increases in step with the code word search steps (32, 33).

**10.** Method according to any one of Claims 1 to 9, characterized in that each of the q binary words to be decoded ($[U^s]$) is constructed in such a way that all its components other than those corresponding to the p indices (r1,..., rp) for which the components of the data vector ([R']) are least reliable are equal respectively to the corresponding components of the decision vector ([D]),

**11.** Method according to Claim 10, characterized in that each of the q binary words to be decoded ($[U^s]$) is constructed in such a way as to have one or two components different from the corresponding components of the decision vector ([D]).

**12.** Method according to Claim 11, characterized in that $q = p(p+1)/2$.

**13.** Method according to any one of Claims 1 to 12, characterized in that the elementary block codes ($C_1$, $C_2$) used in the product code are identical.

**14.** Method for transmitting information bits ($a_j$), comprising:

- a coding phase in which a block code, corresponding to the product of at least two elementary systematic block codes ($C_1$, $C_2$), is applied to the information bits to be transmitted;
- a phase of modulation and of transmission of a signal (E(t)) obtained from the coded information bits ($c_j$);
- a phase of reception of the transmitted signal after propagation and of demodulation; and
- an iterative decoding phase,

characterized in that the iterative decoding phase is executed in accordance with a method according to any one of Claims 1 to 13, in order to detect the information bits ($\hat{a}_j$) in the received signal after demodulation (R(t)).

**15.** Method for retrieving information bits ($a_j$) stored in coded form in a memory, the coding of the said bits having been performed by applying a block code corresponding to the product of at least two elementary systematic block codes ($C_1$, $C_2$), the said method comprising a phase of reading in the memory and a phase of iterative decoding, characterized in that the iterative decoding phase is performed in accordance with a method according to any one of Claims 1 to 13, in order to detect the information bits ($\hat{a}_j$) in the signal supplied by the read phase.

**Patentansprüche**

1. Verfahren zum Detektieren von Informationsbits ($\hat{a}_j$) in einem digitalen codierten Signal (R(t)) im Bereich eines Empfängers (15), wobei die Codierung des digitalen Signals im Bereich eines Senders (10) vorgenommen worden ist, indem man auf zu übertragende Informationsbits ($a_j$) einen Blockcode anwendet, der dem Produkt von wenigstens zwei systematischen elementaren Blockcodes ($C_1$, $C_2$) entspricht, wobei das Verfahren eine Phase iterativer Decodierung umfaßt, die eine Zahl m von Decodierzyklen einschließt, wobei jeder Decodierzyklus fortlaufend Codewortsuchabschnitte (32, 33) für jeden in dem Produktcode verwendeten elementaren Blockcode umfaßt, **dadurch gekennzeichnet,** daß man bei jedem Codewortsuchabschnitt (32, 33) eine Datenmatrix ({R'}) mit mehrwertigen Komponenten und eine Entscheidungsmatrix ({D}) mit binären Komponenten erhält, die vor dem ersten Suchabschnitt der iterativen Decodierphase aus einer aus Proben des empfangenen Signals (R(t)) gebildeten Eingangsmatrix ({R}) bzw. aus einer Matrix gebildet sind, deren Komponenten jene der Eingangsmatrix ({R}) in binärer Form sind, und man eine neue Entscheidungsmatrix ({D}) und eine neue Datenmatrix ({R'}) für den folgenden Suchabschnitt erzeugt, daß die decodierten Informationsbits ($\hat{a}_j$) aus der im letzten Codewortsuchabschnitt erzeugten Entscheidungsmatrix gewonnen werden, und daß jeder Codewortsuchabschnitt (32, 33) eine Aufteilung der erhaltenen Datenmatrix in Datenvektoren ([R']), die jeweils einem Codewort des elementaren Codes entsprechen, und eine entsprechende Aufteilung der erhaltenen Entscheidungsmatrix in Entscheidungsvektoren ([D]) und die folgenden Unterabschnitte umfaßt, um jeweils wenigstens gewisse Paare aus einem Datenvektor und einem Entscheidungsvektor zu behandeln:

   - Bestimmung einer Zahl p von Indizes (r1, ..., rp), für die die Komponenten des Datenvektors ([R']) am wenigsten verläßlich sind;
   - Erstellung einer Zahl q von binären, zu decodierenden Worten ([$U^S$]) ausgehend von den p Indizes und dem Entscheidungsvektor ([D]);
   - Erlangung von q' Codeworten ([$C^S$]) auf der Grundlage algebraischer Decodierungen des Entscheidungsvektors und der zu decodierenden q binären Worte;
   - Auswahl des Codewortes ([$C^d$]) aus den q' erhaltenen Codeworten, welches den geringsten euklidischen Abstand vom Datenvektor ([R']) hat;
   - Berechnung eines Korrekturvektors ([W]), wobei jede Komponente $W_j$ des Korrekturvektors jeweils berechnet wird, indem man ein eventuelles Konkurrenzwort ([$C^c$]) bestimmt, dessen j-te Komponente von jener des ausgewählten Codewortes ([$C^d$]) verschieden ist, und die Formel anwendet:

$$W_j = \left(\frac{\left|M^c - M^d\right|}{4} - C_j^d \cdot R'_j\right) C_j^d$$

     wenn ein Konkurrenzwort bestimmt worden ist, wobei $M^d$ und $M^c$ die euklidischen Abstände des ausgewählten Codewortes ([$C^d$]) bzw, des Konkurrenzwortes ([$C^c$]) vom Datenvektor ([R']) bezeichnen, und $C_j^d$ und $R'_j$ die j-ten Komponenten des ausgewählten Codewortes bzw. des Datenvektors bezeichnen;
   - Erlangung des neuen Entscheidungsvektors ([D]), welcher dem ausgewählten Codewort ([$C^d$]) gleichgesetzt wird; und
   - Berechnung des neuen Datenvektors ([R']), indem man den mit einem ersten Verläßlichkeitskoeffizienten ($\alpha_i$) multiplizierten Korrekturvektor ([W]) zum entsprechenden, aus der Eingangsmatrix ({R}) gewonnenen Eingangsvektor ([R]) addiert.

2. Verfahren nach Anspruch 1, **dadurch gekennzeichnet**, daß im Unterabschnitt zur Berechnung eines Korrekturvektors ([W]) die Bestimmung eines eventuellen Konkurrenzworts ([$C^c$]) bezüglich der j-ten Komponente des ausgewählten Codeworts ([$C^d$]) die Bestimmung derjenigen Codeworte aus den q' erhaltenen Codeworten, deren j-te Komponente von jener des ausgewählten Codeworts verschieden ist, und die Auswahl desjenigen Codeworts aus den so bestimmten Codeworten als Konkurrenzwort umfaßt, welches den kleinsten euklidischen Abstand ($M^c$) vom Datenvektor ([R']) hat, wobei kein Konkurrenzwort bestimmt wird, wenn die q' erhaltenen Codeworte alle eine j-te Komponente besitzen, die jener des ausgewählten Codeworts gleich ist.

**3.** Verfahren nach Anspruch 1, **dadurch gekennzeichnet,** daß im Unterabschnitt zur Berechnung eines Korrekturvektors ([W]) die Bestimmung eines eventuellen Konkurrenzworts ([$C^c$]) bezüglich der j-ten Komponente des ausgewählten Codeworts ([$C^d$]) einen Vergleich zwischen der j-ten Komponente des Entscheidungsvektors ([D]) und jener des ausgewählten Codeworts ([$C^d$]) umfaßt, wobei der Entscheidungsvektor als Konkurrenzwort gewählt wird, wenn seine j-te Komponente von jener des ausgewählten Codeworts verschieden ist, und wobei im entgegengesetzten Fall kein Konkurrenzwort bestimmt wird.

**4.** Verfahren nach einem der Ansprüche 1 bis 3, **dadurch gekennzeichnet,** daß die Erlangung der q' Codeworte für jedes Codewort ([$C^s$]), das aus der algebraischen Decodierung des Entscheidungsvektors oder eines der zu decodierenden q binären Worte resultiert, die Identifizierung der Komponenten des zugeordneten Eingangsvektors umfaßt, die ein zum Vorzeichen der entsprechenden Komponente des Codeworts entgegengesetztes Vorzeichen haben, wobei das Codewort nur dann aus den q' Codeworten behalten wird, wenn die Absolutwerte der Komponenten des Eingangsvektors mit entgegengesetztem Vorzeichen alle unterhalb einer vorher festgesetzten Schwelle ($\gamma_i$) liegen.

**5.** Verfahren nach Anspruch 4, **dadurch gekennzeichnet,** daß die Schwelle ($\gamma_i$) im Verlauf der Codewortsuchabschnitte (32, 33) nach und nach wächst.

**6.** Verfahren nach einem der Ansprüche 1 bis 5, **dadurch gekennzeichnet,** daß der erste Verläßlichkeitskoeffizient ($\alpha_i$) im Verlauf der Codewortsuchabschnitte (32, 33) nach und nach wächst.

**7.** Verfahren nach einem der Ansprüche 1 bis 6, **dadurch gekennzeichnet,** daß die Berechnung jeder Komponente $W_j$ des Korrekturvektors ([W]) in Abwesenheit der Bestimmung eines Konkurrenzworts bezüglich dieser Komponente nach der Formel erfolgt:

$$W_j = \beta_i C_j^d$$

worin $\beta_i$ einen zweiten Verläßlichkeitskoeffizienten bezeichnet.

**8.** Verfahren nach einem der Ansprüche 1 bis 6, **dadurch gekennzeichnet,** daß die Berechnung jeder Komponente $W_j$ des Korrekturvektors ([W]) in Abwesenheit der Bestimmung eines Konkurrenzworts bezüglich dieser Komponente nach der Formel erfolgt:

$$W_j = (\beta_i - C_j^d R'_j) C_j^d$$

worin $\beta_i$ einen zweiten Verläßlichkeitskoeffizienten bezeichnet.

**9.** Verfahren nach Anspruch 7 oder 8, **dadurch gekennzeichnet,** daß der zweite Verläßlichkeitskoeffizient ($\beta_i$) im Verlauf der Codewortsuchabschnitte (32, 33) nach und nach wächst.

**10.** Verfahren nach einem der Ansprüche 1 bis 9, **dadurch gekennzeichnet,** daß jedes der zu decodierenden q binären Worte ([$U^S$]) so gebildet ist, daß all seine Komponenten, außer den Komponenten, die den p Indizes (r1, ..., rp) entsprechen, für die die Komponenten des Datenvektors ([R']) am wenigstens verläßlich sind, jeweils gleich den entsprechenden Komponenten des Entscheidungsvektors ([D]) sind.

**11.** Verfahren nach Anspruch 10, **dadurch gekennzeichnet,** daß jedes der zu decodierenden q binären Worte ([$U^S$]) so gebildet ist, daß es ein oder zwei Komponenten hat, die von den entsprechenden Komponenten des Entscheidungsvektors ([D]) verschieden sind.

**12.** Verfahren nach Anspruch 11, **dadurch gekennzeichnet,** daß $q = p(p+1)/2$ ist.

**13.** Verfahren nach einem der Ansprüche 1 bis 12, **dadurch gekennzeichnet**, daß die im Produktcode verwendeten

elementaren Blockcodes ($C_1$, $C_2$) identisch sind.

**14.** Verfahren zum Übertragen von Informationsbits ($a_j$), umfassend:

- eine Codierphase, in der man auf die zu übertragenden Informationsbits einen Blockcode anwendet, der dem Produkt von wenigstens zwei systematischen elementaren Blockcodes ($C_1$, $C_2$) entspricht;
- eine Modulations- und Sendephase eines Signals (E(t)), das ausgehend von codierten Informationsbits ($c_j$) erhalten worden ist;
- eine Phase des Empfangs des gesendeten Signals nach seiner Ausbreitung und der Demodulation; und
- eine Phase iterativer Decodierung,

**dadurch gekennzeichnet,** daß die Phase iterativer Decodierung gemäß einem Verfahren nach einem der Ansprüche 1 bis 13 durchgeführt wird, um die Informationsbits ($\hat{a}_j$) in dem nach Demodulation erhaltenen Signal (R (t)) zu detektieren.

**15.** Verfahren zum Wiedergewinnen von Informationsbits ($a_j$), die in codierter Form in einem Speicher gespeichert sind, wobei die Codierung der Bits durch Anwenden eines Blockcodes erfolgt ist, der dem Produkt von wenigstens zwei systematischen elementaren Blockcodes ($C_1$, $C_2$) entspricht, wobei das Verfahren eine Phase des Einlesens in den Speicher und eine Phase iterativer Decodierung umfaßt, **dadurch gekennzeichnet,** daß die Phase iterativer Decodierung gemäß einem Verfahren nach einem der Ansprüche 1 bis 13 erfolgt, um die Informationsbits ($\hat{a}_j$) in dem von der Einlesephase gelieferten Signal zu detektieren.

FIG. 1

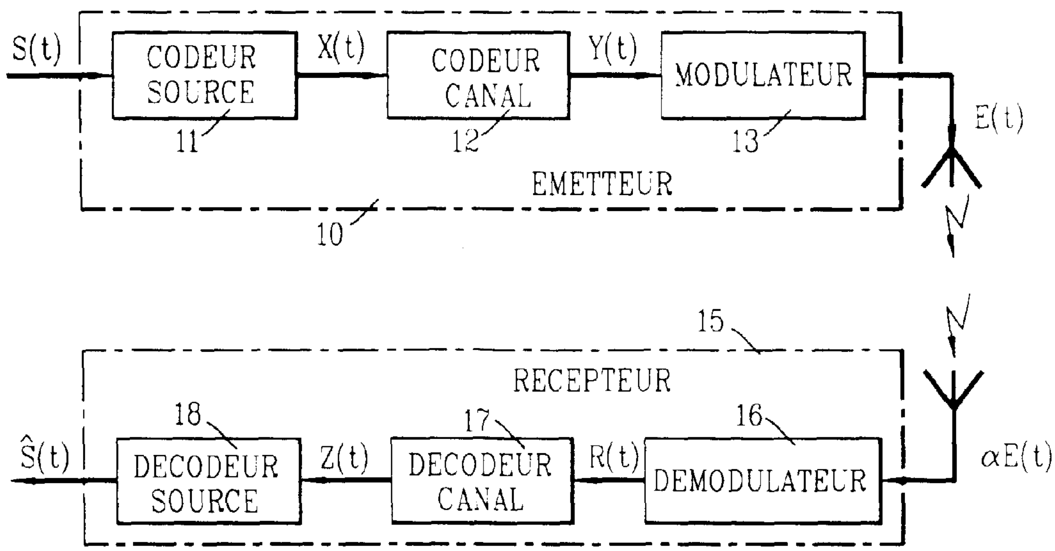
S(t)
CODEUR SOURCE
X(t)
CODEUR CANAL
Y(t)
MODULATEUR
E(t)
11
12
13
EMETTEUR
10
15
RECEPTEUR
18
17
16
Ŝ(t)
DECODEUR SOURCE
Z(t)
DECODEUR CANAL
R(t)
DEMODULATEUR
αE(t)

FIG. 2

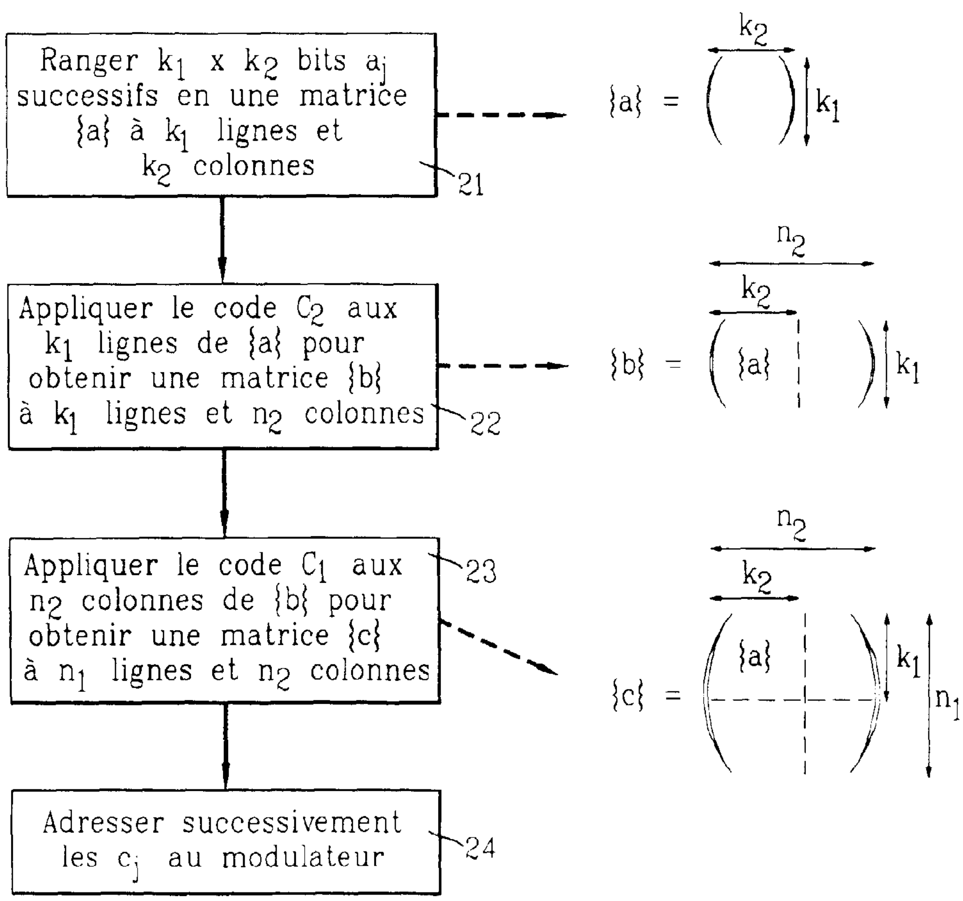
Ranger $k_1$ x $k_2$ bits $a_j$ successifs en une matrice {a} à $k_1$ lignes et $k_2$ colonnes
21
{a} =
$k_2$
$k_1$
Appliquer le code $C_2$ aux $k_1$ lignes de {a} pour obtenir une matrice {b} à $k_1$ lignes et $n_2$ colonnes
22
{b} =
$n_2$
$k_2$
{a}
$k_1$
Appliquer le code $C_1$ aux $n_2$ colonnes de {b} pour obtenir une matrice {c} à $n_1$ lignes et $n_2$ colonnes
23
{c} =
$n_2$
$k_2$
{a}
$k_1$
$n_1$
Adresser successivement les $c_j$ au modulateur
24

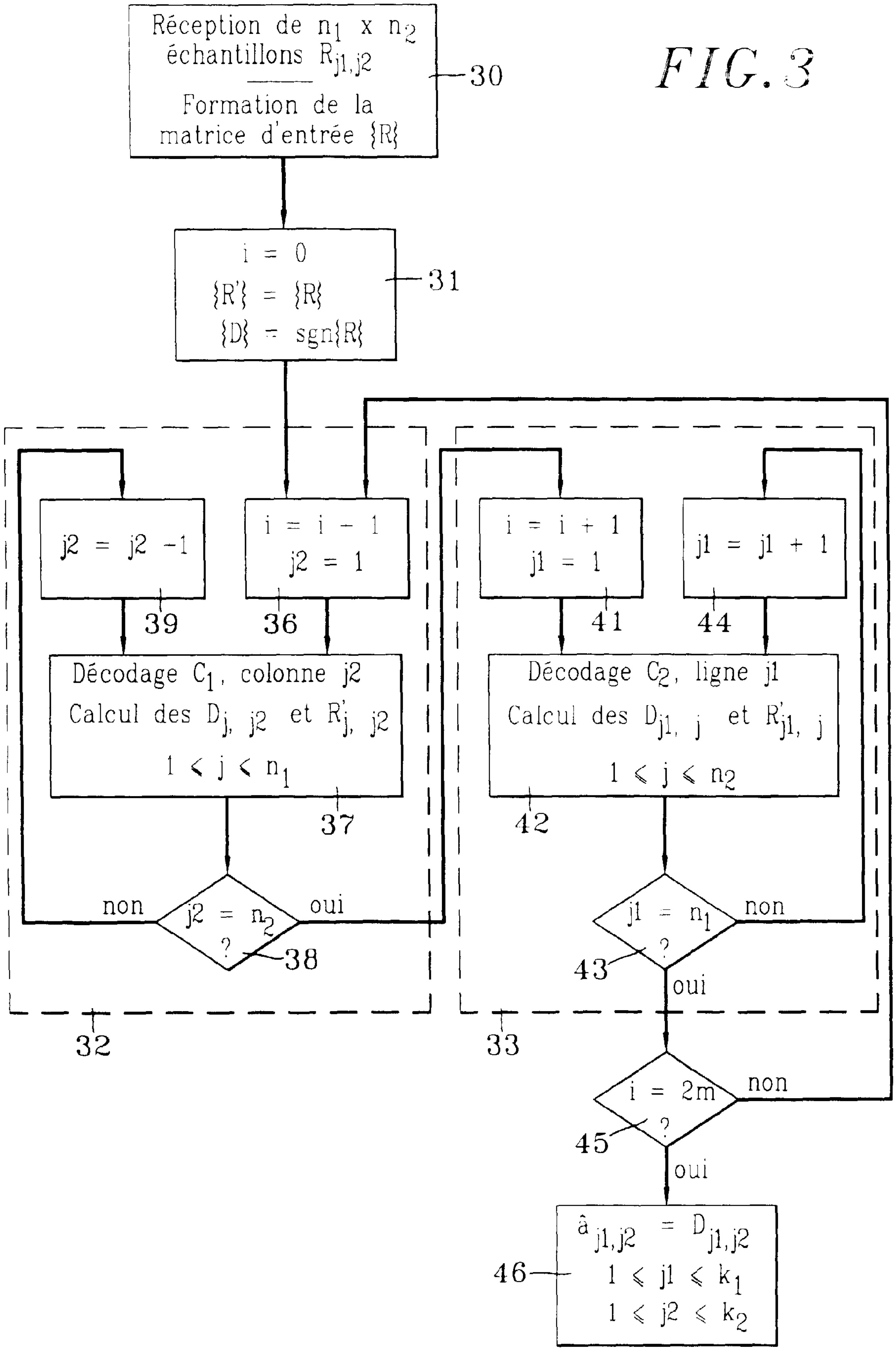
Réception de $n_1$ x $n_2$ échantillons $R_{j1,j2}$
Formation de la matrice d'entrée {R}
30
i = 0
{R'} = {R}
{D} = sgn{R}
31
j2 = j2 -1
39
i = i - 1
j2 = 1
36
Décodage $C_1$, colonne j2
Calcul des $D_{j,j2}$ et $R'_{j,j2}$
$1 \leq j \leq n_1$
37
j2 = $n_2$ ?
38
non
oui
32
i = i + 1
j1 = 1
41
j1 = j1 + 1
44
Décodage $C_2$, ligne j1
Calcul des $D_{j1,j}$ et $R'_{j1,j}$
$1 \leqslant j \leqslant n_2$
42
j1 = $n_1$ ?
43
non
oui
33
i = 2m ?
45
non
oui
$\hat{a}_{j1,j2} = D_{j1,j2}$
$1 \leqslant j1 \leqslant k_1$
$1 \leqslant j2 \leqslant k_2$
46

FIG. 3

FIG. 4

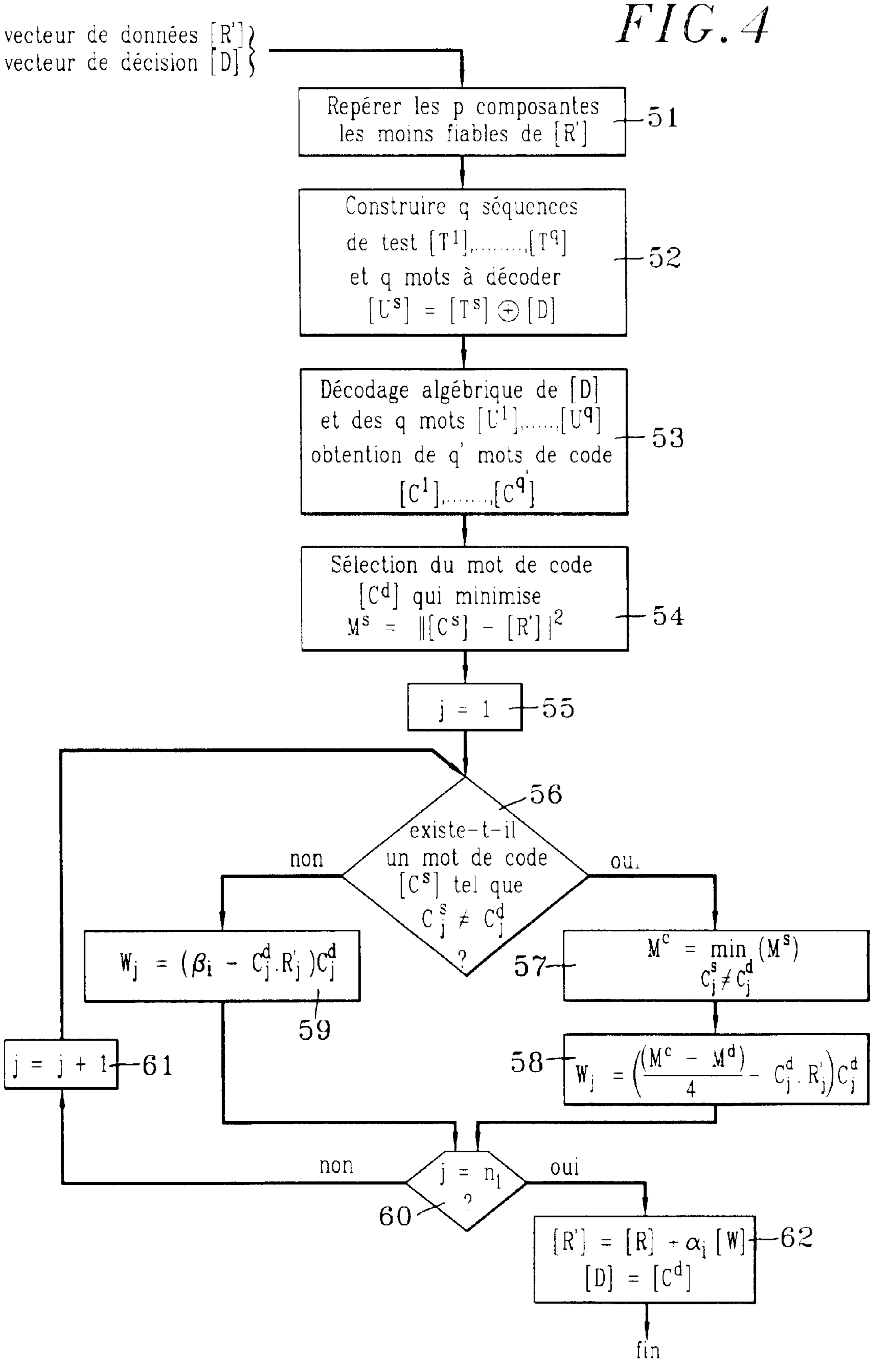
vecteur de données [R']
vecteur de décision [D]
Repérer les p composantes les moins fiables de [R']
51
Construire q séquences de test [T1],........,[Tq] et q mots à décoder [Us] = [Ts] ⊕ [D]
52
Décodage algébrique de [D] et des q mots [U1],......,[Uq] obtention de q' mots de code [C1],.......,[Cq']
53
Sélection du mot de code [Cd] qui minimise Ms = ‖[Cs] - [R']‖2
54
j = 1
55
56
existe-t-il un mot de code [Cs] tel que Cjs ≠ Cjd ?
non
oui
Wj = (βi - Cjd.R'j)Cjd
59
57
Mc = min (Ms) Cjs≠Cjd
58
Wj = ((Mc - Md)/4 - Cjd.R'j)Cjd
j = j + 1
61
j = n1 ?
60
non
oui
[R'] = [R] + αi [W]
[D] = [Cd]
62
fin

FIG. 5

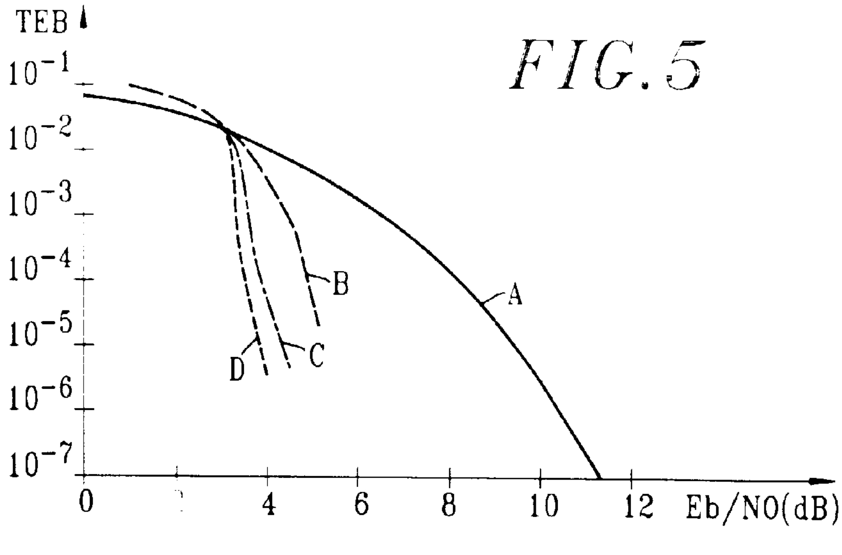


FIG. 6

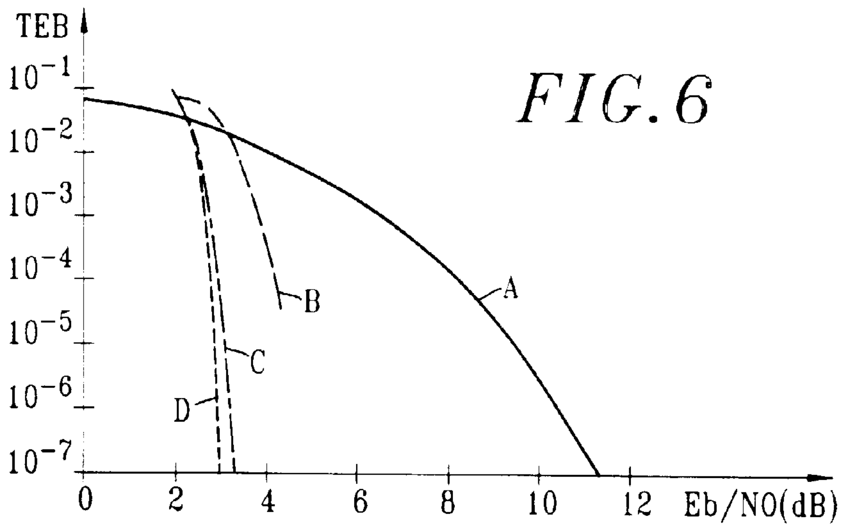


FIG. 7

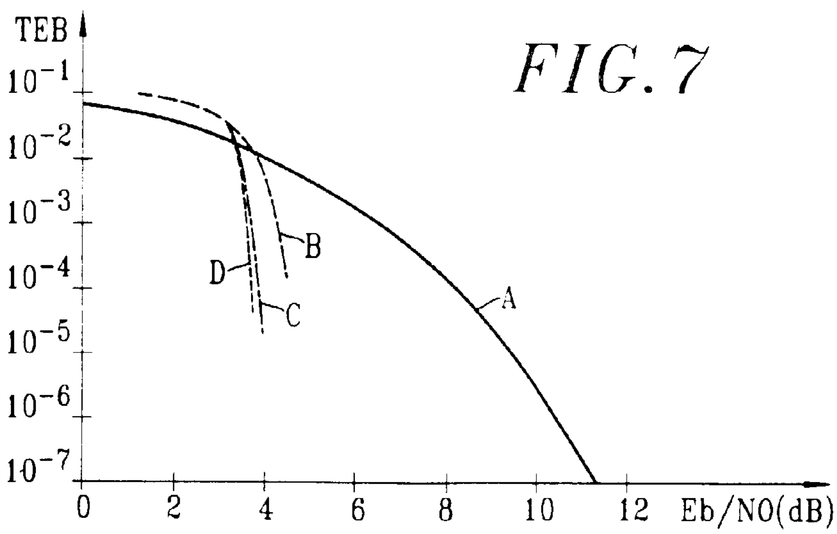

FIG.8

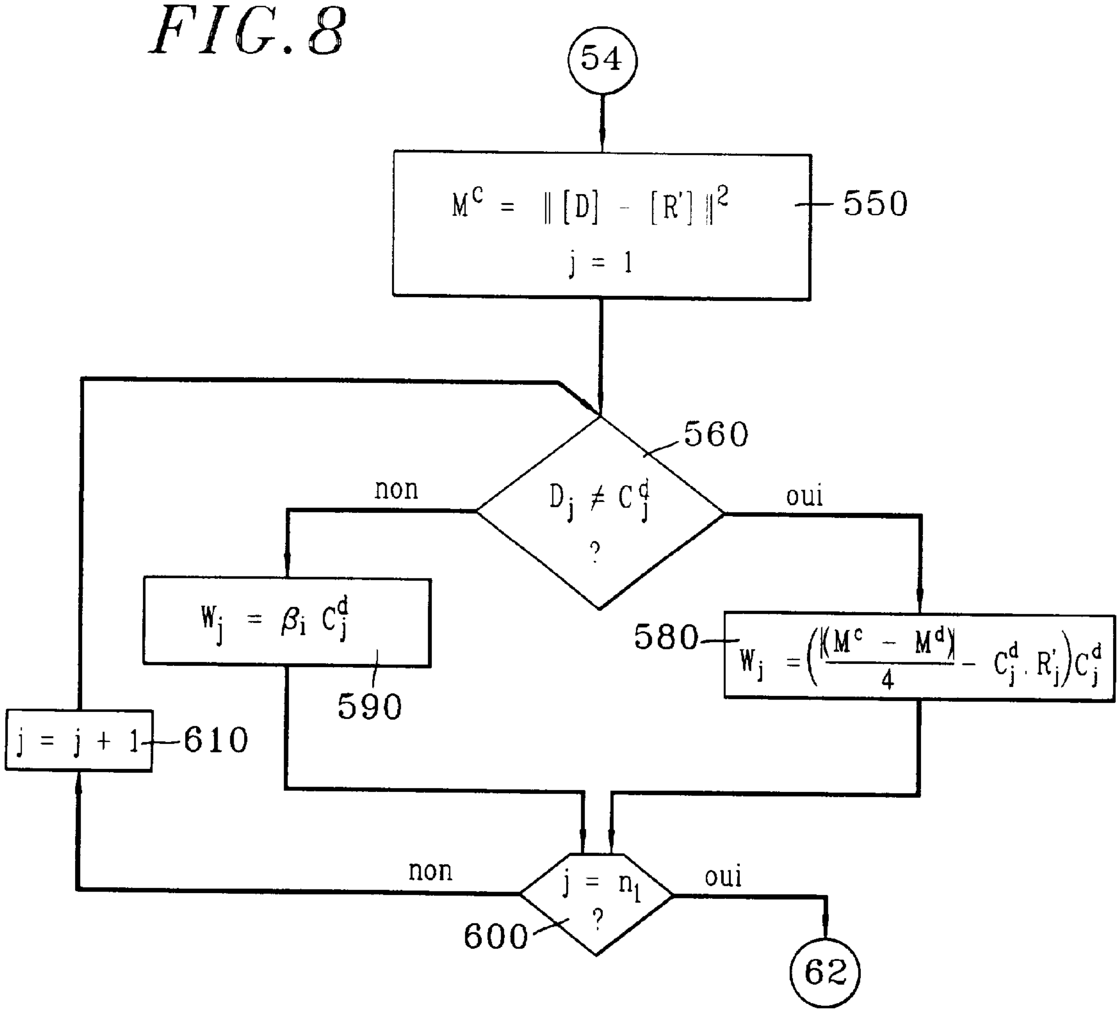
54
$M^c = \| [D] - [R'] \|^2$
j = 1
550
560
non
$D_j \neq C_j^d$
?
oui
$W_j = \beta_i C_j^d$
590
580
$W_j = \left(\frac{|M^c - M^d|}{4} - C_j^d . R'_j\right) C_j^d$
j = j + 1
610
non
j = $n_1$
?
oui
600
62

FIG.10

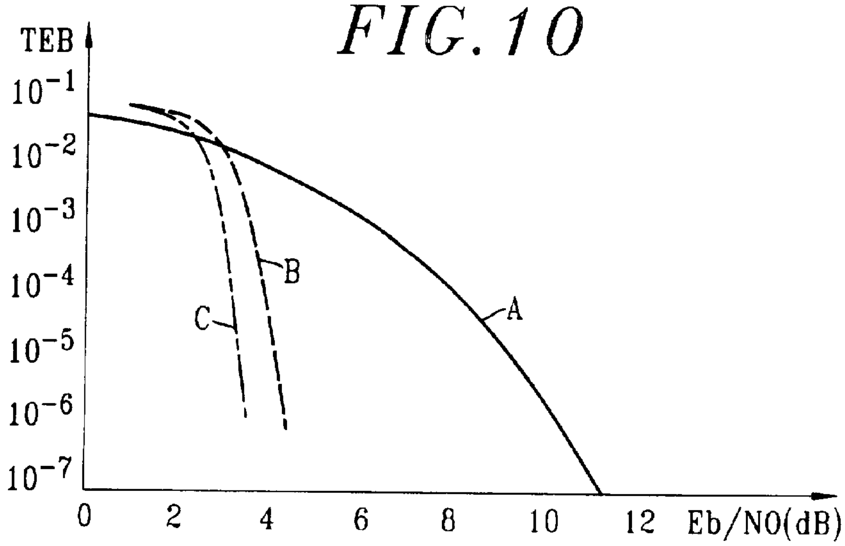
TEB
$10^{-1}$
$10^{-2}$
$10^{-3}$
$10^{-4}$
$10^{-5}$
$10^{-6}$
$10^{-7}$
B
C
A
0
2
4
6
8
10
12
Eb/NO(dB)

FIG. 9

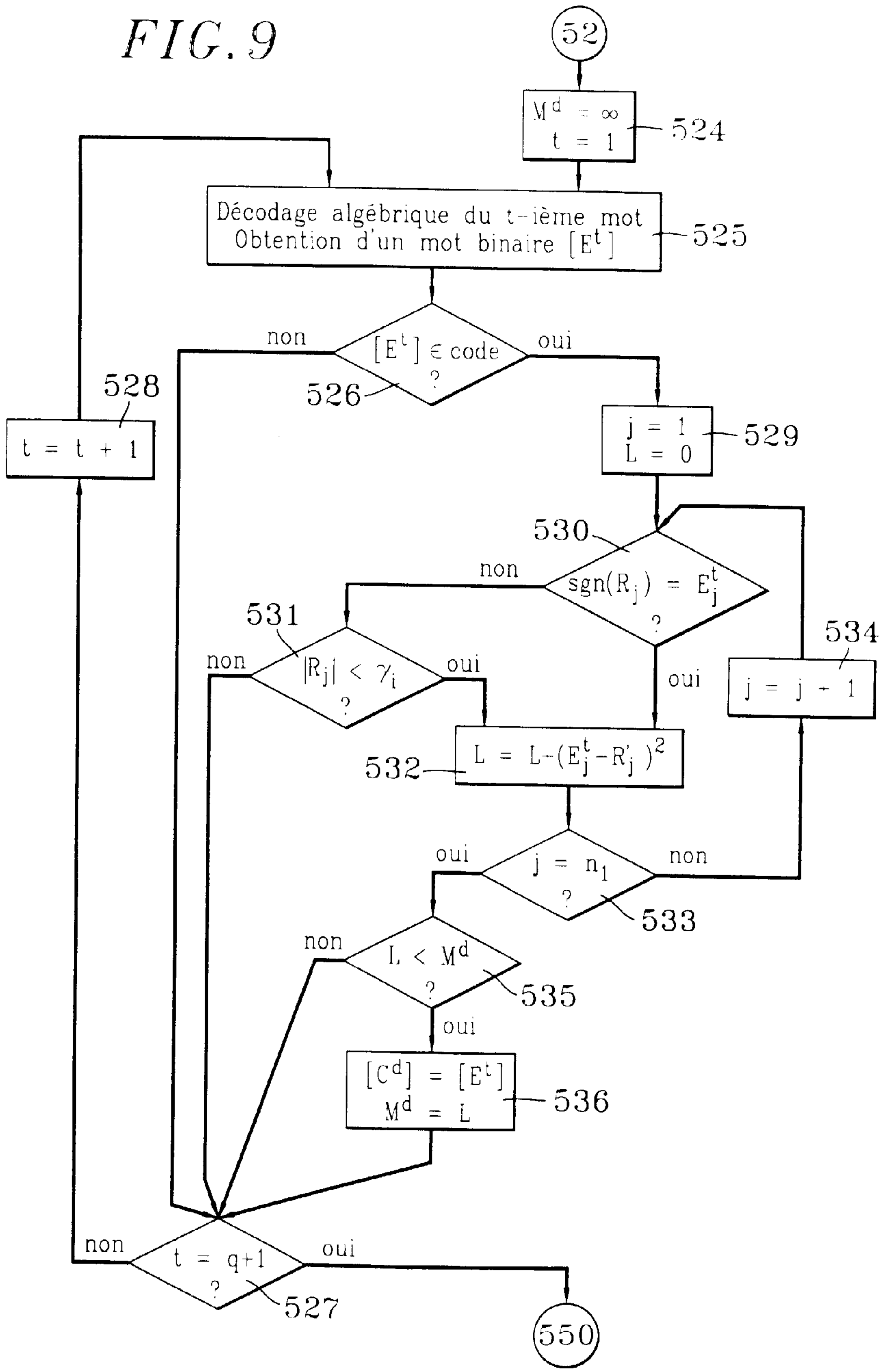
52
$M^d = \infty$
$t = 1$
524
Décodage algébrique du t-ième mot
Obtention d'un mot binaire $[E^t]$
525
$[E^t] \in$ code ?
526
non
oui
528
$t = t + 1$
$j = 1$
$L = 0$
529
530
$sgn(R_j) = E_j^t$ ?
non
oui
531
$|R_j| < \gamma_i$ ?
non
oui
534
$j = j + 1$
532
$L = L-(E_j^t - R'_j)^2$
$j = n_1$ ?
oui
non
533
$L < M^d$ ?
non
oui
535
$[C^d] = [E^t]$
$M^d = L$
536
$t = q+1$ ?
non
oui
527
550

FIG. 11

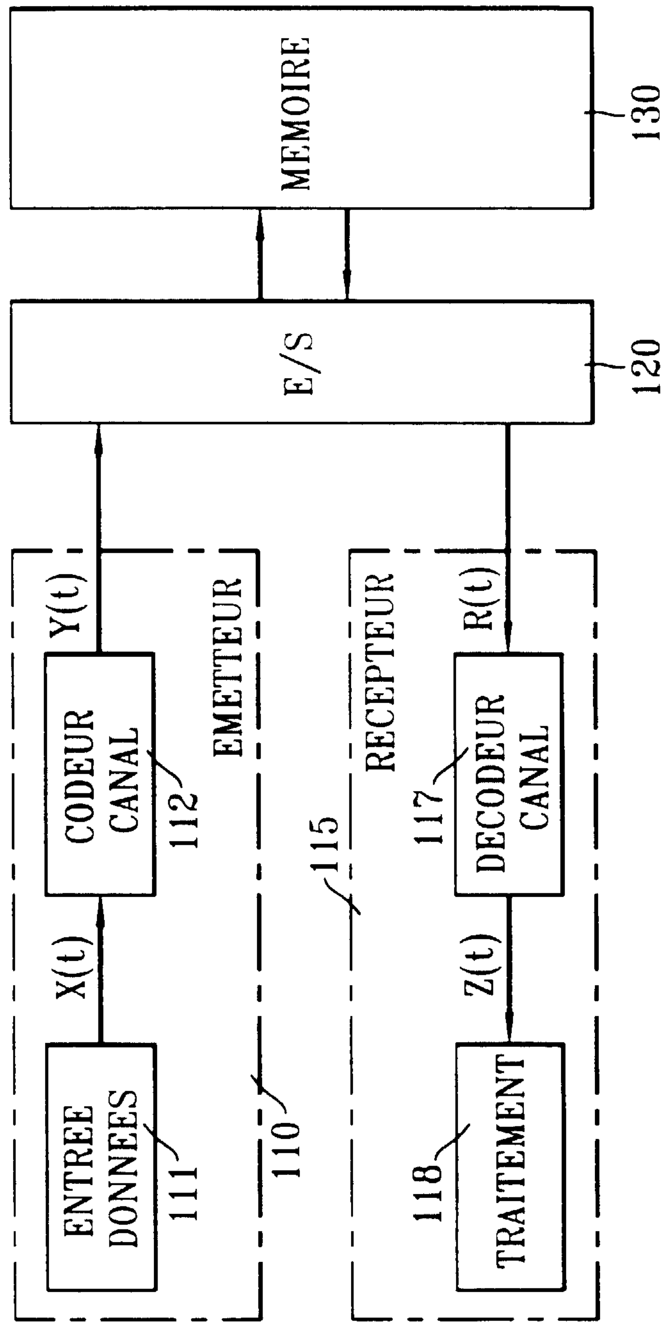
MEMOIRE
130
E/S
120
Y(t)
EMETTEUR
CODEUR CANAL
112
X(t)
ENTREE DONNEES
111
110
115
RECEPTEUR
R(t)
DECODEUR CANAL
117
Z(t)
TRAITEMENT
118